# EUROPEAN PATENT APPLICATION

(11) **EP 4 811 568 A1**
(43) Date of publication of application: **23.09.2026**
(21) Application number: 25165488.5
(22) Date of filing: 21.03.2025
(51) Int. Cl.: H01S 5/024, H01S 5/026, H01S 5/06, H01S 5/068, H01S 5/22, H01S 5/10, H01S 5/12

(54) **SEMICONDUCTOR LASER CHIP WITH INTEGRATED HEATER ELEMENT**

(71) Applicant: Sensirion AG, 8712 Stäfa (CH)
(72) Inventor: HILLBRAND, Johannes, 8712 Stäfa (CH); OPACAK, Nikola, 8712 Stäfa (CH); SAUDAN, Quentin, 8712 Stäfa (CH); UEHLINGER, Thomas, 8712 Stäfa (CH); NEUENSCHWANDER, Matthias, 8712 Stäfa (CH); RISQUEZ, Sarah, 8712 Stäfa (CH); JOUY, Pierre, 8712 Stäfa (CH)
(74) Representative: Haines, Miles John L.S.

(57) **Abstract**

A semiconductor laser chip 100 comprising a semiconductor laser 1 formed from a stack of semiconductor layers 10 including active region layers 20 and upper and lower cladding layers arranged above and below the active region layers. The semiconductor layer stack is structured by a ridge 12₁ for the semiconductor laser 1. The upper and lower cladding layers and the ridge 12₁ collectively define a waveguide in the active region layers 20 that supports an optical mode 28 for lasing. A heater element 2 and a temperature sensor 3 are monolithically integrated with the semiconductor layer stack. Monolithic integration of a heater element 2 and a temperature sensor 3 on the semiconductor laser chip 100 allows closed-loop control of the temperature of the semiconductor laser 1. The semiconductor laser 1 can thus be temperature stabilized and also have its emission wavelength tuned by varying its temperature.

## Description

### BACKGROUND OF THE INVENTION

The invention relates to semiconductor laser chips with integrated heater elements.

The emission wavelength of single-mode monolithic semiconductor laser is dependent on the temperature of the semiconductor material that the lasing cavity mode samples, i.e., essentially the semiconductor material that forms the waveguide within the laser cavity. As a result, the emission wavelength and also the output power of the laser depend strongly on the temperature. In a distributed feedback (DFB) laser, for example, a mode-selecting grating is arranged in the cavity and the effective refractive index and hence the resonant wavelengths of the Bragg grating are a function of temperature of the semiconductor material sampled by the lasing cavity mode. Temperature control of the semiconductor chip can therefore be used to provide tuning of the laser emission wavelength. Moreover, temperature stabilization is important for stabilizing the laser output power.

For temperature control and stabilization, it is common practice to attach the semiconductor laser chip to a submount that is in turn in thermal contact with a thermoelectric element. The thermoelectric element is used to control the chip temperature and hence tune and stabilize the laser emission wavelength and to stabilize the output power. Using a Peltier element as the thermoelectric element advantageously allows both cooling and heating to be performed. Employing a thermoelectric element does however add bulk and cost. Moreover, the thermoelectric element and associated packaging elements, such as the submount, have thermal mass, which means that significant power consumption and time delay is associated with changing the temperature of the packaged laser chip.

To gain faster temperature tuning times and to reduce power consumption, it is known to integrate a heater element on the semiconductor laser chip instead of, or in combination with, packaging the chip with a thermoelectric element. Integrated heater elements are functionally more limited than Peltier elements, since they can only provide heating but not cooling. They thus only allow the laser to be heated above environmental temperature but nevertheless provide a tuning capability without requiring external off-chip components. Some examples of semiconductor laser chips with integrated heaters are as follows.

US2016094013A1 assigned to Applied Optoelectronics, Inc. [1] discloses an edge-emitting laser diode chip such as a distributed feedback (DFB) laser or a distributed Bragg reflector (DBR) laser based on an interband transition in a multi-quantum well (MQW) active region. A heater element is arranged to one side of the linear laser cavity, the heater element and laser being separated by a trench that is filled with insulator. The heater element is activated by passing current vertically through the chip to cause Ohmic heating in the active region layers. The heat then travels laterally through the semiconductor material under the trench to heat the volume of the active region layers sampled by the lasing cavity mode. Efficient heat transfer is provided, since the semiconductor material has good thermal conductivity. The integrated heater element is used as part of a temperature control system that further comprises a thermoelectric cooler (TEC) that is thermally coupled to the laser chip and operates in combination with the integrated heater to control the emission wavelength of the laser by combined heating and cooling.

US2015078411A1 [2] assigned to Alpes Lasers SA discloses an edge-emitting laser diode chip such as a DFB or DBR laser with an integrated heater element. The laser is a quantum cascade laser (QCL). Compared to a standard laser structure, an additional secondary top electrode is provided to one side of the laser waveguide. A trench is formed by etching through a part of the depth of the upper cladding layer. Current injection through the secondary electrode flows in a lateral current path through the relatively resistive thinned portion of the upper cladding layer under the trench to the active region layers, which causes resistive heating to heat the thinned portion. The heat is then transferred by thermal conduction to the laser waveguide, i.e., the volume of the active region layers sampled by the lasing cavity mode. By comparison, current injected from the primary electrode located directly above the active region layers flows directly into the active region layers. The resistive heating of the thinned portion of the upper cladding thus heats up the semiconductor material sampled by the cavity mode. Varying the current injected through the secondary electrode is thus used to tune the emission wavelength.

WO2015081220A1 [3] assigned to Thorlabs Quantum Electronics, Inc. discloses an edge-emitting laser diode chip such as a DFB or DBR laser, with an active region that forms a QCL, interband cascade laser (ICL) or an interband MQW laser. A microheater is arranged on the top surface of the chip directly above the active region, with current injection electrodes being arranged either side of the microheater. A microheater can be realized as a thin metal film with a resistive path that generates Joule heating when a current is passed through it. The microheater allows the temperature of the active region layers to be changed rapidly with a rise time of a few tens of microseconds.

### SUMMARY OF THE INVENTION

According to the invention, there is provided a semiconductor laser chip comprising:
a semiconductor laser formed from a stack of semiconductor layers including active region layers and upper and lower cladding layers arranged above and below the active region layers, the semiconductor layer stack being structured laterally to define a waveguide having an optical mode that samples the active region layers;
a heater element formed integrally with the semiconductor laser stack and extending alongside the waveguide, the heater element being electrically actuatable to provide a heat source; and
a temperature sensor formed integrally with the semiconductor layer stack.

Integration of a heater element and a temperature sensor on the semiconductor laser chip allows closed-loop control of the temperature. The amount of heat generated by the heater element can be controlled through its electrical actuation, e.g., applied voltage or current, to set the temperature of the waveguide core, i.e., the active region layers sampled by the lasing cavity mode. Temperature stabilization is particularly important for ring lasers. More especially, for a laser that incorporates a grating extending along the cavity direction, any variation of temperature along the grating will cause undesired local periodicity variations along the grating. Such gratings may be provided for mode-selection (e.g. first order grating for DFB) and/or outcoupling (e.g. second order grating for lateral or vertical outcoupling). The signal provided by the temperature sensor allows the heating power of the heater element to be varied in a control loop such that the temperature of the semiconductor material sampled by the lasing optical mode remains stable. Temperature can thus be held constant when changes in the environment temperature occur.

In certain embodiments, the heater element and the temperature sensor are separated by a first distance, and the heater element and the semiconductor laser are separated by a second distance. The first distance and the second distance are selected by design such that, during actuation of the heater element, the temperature experienced by the temperature sensor and the temperature experienced by the semiconductor laser (more exactly the volume of semiconductor material sampled by the lasing cavity mode) are the same. Thermal modelling of the chip is done during the design phase to ensure the two temperatures will be the same, or as close to each other as possible over the range of heat flux that can be provided by varying the applied voltage and/or current that is applied to actuate the heater element. Approximate equality between these two temperatures can be expressed in terms of their ratio. Specifically, the first distance and the second distance can be selected such that, during activation of the heater element, the ratio of the temperature increase experienced by the temperature sensor to the temperature increase experienced by the semiconductor laser (in both cases compared to the temperature pertaining when the heater element is deactivated), more exactly the volume of semiconductor material sampled by the lasing cavity mode, is close to unity, for example within the range 0.5 to 1.5, more preferably 0.7 to 1.3, still more preferably 0.8 to 1.2, yet more preferably 0.9 to 1.1. For a linear cavity, it can be expected that the temperature gradient either side of the heater element will be symmetric, in which case equal distance will correspond closely to equal values of the temperature differences. Therefore, for linear cavities, a simple geometric expression of the same criterion will hold, namely that the ratio of the first distance to the second distance is close to unity, in particular within the range 0.5 to 1.5, more preferably 0.7 to 1.3, still more preferably 0.8 to 1.2, yet more preferably 0.9 to 1.1. On the other hand, for a ring cavity, the temperature gradients either side of the heater element will in most cases be asymmetric, with the amount of asymmetry increasing with decreasing ring size. This is because cooling radially inwards will be less efficient than radially outwards, so the distance from the heater element radially inwards to the temperature sensor (or laser) will need to be greater than the distance from the heater element radially outwards to the semiconductor laser (or temperature sensor) to ensure that the temperature sensor experiences the same temperature as the semiconductor laser when the heater element is being actuated. The above simple geometric expression will therefore still be a good approximation for large rings but will become increasingly inappropriate as ring size reduces.

In some embodiments, the semiconductor laser and the temperature sensor are arranged on opposite sides of the heater element. In other embodiments, the semiconductor laser and the temperature sensor are arranged on the same side of the heater element, for example with the temperature sensor being arranged on top of the semiconductor laser.

The lateral structure of the semiconductor layer stack that defines the waveguide, together with the upper and lower cladding layers of the semiconductor layer stack, may be in the form of a ridge. The core of the waveguide is arranged to ensure that there is significant overlap between the guided optical mode and the active region layers. Moreover, if one or more gratings are included for mode selection and/or outcoupling, the waveguide core is arranged such that there is some overlap between the guided optical mode and the grating(s). So-called buried heterostructure laser design or so-called ridge waveguide designs may be used.

One class of semiconductor laser to which the invention may be applied is a semiconductor ring laser whose cavity is formed as a waveguide in the shape of a closed loop, the waveguide being formed in the plane of the semiconductor heterostructure layers that are deposited epitaxially on a planar substrate. The term ring in the context of the invention includes not only circular ring waveguides but also other suitable closed loop waveguide shapes that are capable of supporting suitable cavity modes, such as ellipses or ovals, or racetrack shapes with two straights connected by two bends. To form the waveguide in the shape of a closed loop, the ridge can be formed to extend in a closed loop.

Another class of semiconductor laser to which the invention may be applied is an edge-emitting semiconductor laser whose cavity is linear and is bounded by front and back end facets of the semiconductor laser chip. In such an edge-emitting semiconductor laser the cavity end faces are most commonly formed by cleaved crystal faces which ensures the front and back facets are exactly parallel to each other. Another option is to form one or both of the end facets with etching, such as reactive ion etching. The end facets may be coated with metals and/or dielectric material layers to form mirror surfaces for the linear cavity, namely a back (or rear) reflector and an output coupler (or front reflector).

A further class of semiconductor laser to which the invention may be applied is DBR semiconductor lasers, where the cavity mirrors are formed by first-order gratings.

The heater element in certain embodiments takes the form of a strip extending parallel to the semiconductor laser, more exactly the volume of semiconductor material sampled by the lasing cavity mode. The parallel arrangement means that there is a constant fixed distance between the heater element and the laser's waveguide core along the length of the heater element. The fixed distance ensures that the volume of semiconductor material sampled by the lasing cavity mode is heated evenly in the cavity direction along the length of the heater element. The heater element may extend over the whole length of the cavity or may extend only over a limited portion of the length of the cavity, e.g., to match the length of a DFB grating.

There are different options for forming the heater element as an integral part of the semiconductor laser chip. By way of example, the heater element can be selected from the group:
a heater element formed integrally with the semiconductor layer stack that is operable to generate heat by passing electrical current through the active region layers, the heater element being electrically actuatable independent of the semiconductor laser;
a heater element formed integrally with the semiconductor layer stack that is operable to generate heat by passing electrical current through a doped semiconductor layer of the semiconductor layer stack, the heater element being electrically actuatable independent of the semiconductor laser; and
a microheater element in the form of a metal strip arranged on the top surface of the semiconductor layer stack that is operable to generate heat by application of an electrical voltage to cause resistive heating.

Depending on the kind of heater element the electrical drive may be by way of a drive current or a drive voltage. Moreover, the electrical drive may be continuous, being actuated with a DC drive signal, or may be pulsed with a certain pulse duration and duty cycle, being actuated with an AC drive signal, such as a so-called pulse width modulated (PWM) AC drive signal. In the case of pulsed drive, the duty cycle may either be fixed or varied, for example with variation responsive to the signal from the temperature sensor.

There are different options for forming the temperature sensor as an integral part of the semiconductor laser chip. By way of example, the temperature sensor can be selected from the group:
a resistive temperature sensor formed within the semiconductor layer stack, the resistive temperature sensor being operable to measure temperature through temperature variation of the resistance of the active region layers;
a pn-junction temperature sensor formed integrally with the semiconductor layer stack, the pn-junction temperature sensor being operable to measure temperature through temperature variation of leakage current across the pn-junction when the pn-junction is in reverse bias;
a resistance temperature detector comprising a metal film arranged on the top surface of the semiconductor layer stack, the resistance temperature detector being operable to measure temperature through temperature variation of the resistance of the metal film; and
a thermocouple comprising an electrically conductive path formed by first and second serially connected metal films of different metals arranged on the top surface of the semiconductor layer stack, the thermocouple being operable to measure temperature through temperature variation of voltage between the ends of the electrically conductive path.

One kind of semiconductor laser to which the invention may be applied is a quantum cascade laser (QCL) whose lasing action is based on cascading intraband transitions between subbands of quantum wells in a Type I superlattice structure. QCLs emit in the infrared. Another kind of semiconductor laser to which the invention may be applied is an interband cascade laser (ICL) whose lasing action is based on cascading interband transitions between subbands of quantum wells in a Type II (or sometimes Type I) superlattice structure. Another kind of semiconductor laser to which the invention may be applied is one based on a conventional laser diode (LD) heterostructure, i.e., using an interband transition of a Type I single or multi-quantum well (MQW) heterostructure. Another kind of semiconductor laser to which the invention may be applied is a quantum dot laser, e.g. using epitaxially grown semiconductor quantum dots as gain material. QCLs, ICLs, LDs and quantum dot lasers according to embodiments of the invention may be implemented as ring cavity semiconductor lasers or linear cavity edge-emitting semiconductor lasers.

In embodiments with a ring cavity, the waveguide of the semiconductor laser can be formed of a ridge of semiconductor material having an inner sidewall and an outer sidewall, and the semiconductor laser further may further comprise:
a mode selecting grating arranged on at least one of the inner and outer sidewalls to define the ring cavity, the ring cavity being configured to support a radiative and a non-radiative mode, the non-radiative mode having lower losses than the radiative mode so that the non-radiative mode becomes the lasing mode; and
an output coupler arranged on at least one of the inner and outer sidewalls and configured such that local to the output coupler the non-radiative mode that is the lasing mode is forced into a radiative mode, or a mixed radiative and non-radiative mode, thereby to couple laser light out of the ring waveguide through at least one of the inner and outer sidewalls.

It is also possible to use this output coupler design without the heater and integrated temperature sensor. Namely, according to another aspect of the invention, there is provided a semiconductor ring laser comprising:
a ring waveguide formed of a ridge of semiconductor material having an inner sidewall and an outer sidewall;
a mode selecting grating arranged on at least one of the inner and outer sidewalls to define a ring cavity that supports a radiative and a non-radiative mode, the non-radiative mode having lower losses than the radiative mode so that the non-radiative mode becomes the lasing mode; and
an output coupler arranged on at least one of the inner and outer sidewalls and configured such that local to the output coupler the non-radiative mode that is the lasing mode is forced into a radiative mode, or a mixed radiative and non-radiative mode, thereby to couple laser light out of the ring waveguide through at least one of the inner and outer sidewalls.

According to this design of output coupler, it is possible to provide a semiconductor ring laser of monolithic construction based on a lateral grating for mode selection and an output coupler whose outcoupling efficiency is not affected by small process variations. It is therefore possible to mass manufacture semiconductor ring lasers at low cost with high yield.

In certain embodiments, the output coupler is realized as an output coupling grating. Being arranged on one or both of the ridge sidewalls, the output coupler grating is a lateral grating. Therefore, both the mode selection and output coupling are realized by respective lateral gratings which operate in combination to provide their respective functions in which the mode selecting lateral grating ensures that the non-radiative mode becomes the lasing mode and the output coupling grating forces the lasing mode into a radiative mode, or a mixed radiative and non-radiative mode, in the part of the ring local to the output coupling grating.

The mode selecting grating and the output coupling grating may be arranged serially on a common one of the inner and outer sidewalls of the ring waveguide. Alternatively, the mode selecting grating may extend around the whole ring on one sidewall and the output coupling grating over a limited portion of the ring, e.g., defined by azimuthal angle, on the other sidewall. For example, the output coupling grating may extend over an azimuthal angle *ϕ* selected from the group: less than or equal to 90 degrees (*π*/2); less than or equal to 45 degrees (*π*/4); and less than or equal to 30 degrees (*π*/6). Other permutations for the relative lengths and sidewall placements of the mode selecting grating and the output coupling grating are possible.

In one specific design, the output coupling grating and the mode selecting grating have a common period and respective first and second azimuthal mode numbers, denoted *m*₁, *m*₂, that are equal, and wherein the output coupling grating and the mode selecting grating have a phase offset. In this design, the phase offset may be selected to approximate to a quarter of the common period, i.e., 90 degrees (*π*/2), in a range selected from the group:
90±80 degrees;
90±70 degrees;
90±60 degrees;
90±50 degrees;
90±40 degrees; and
90±30 degrees.

In another specific design, the mode selecting grating and the output coupling grating have respective first and second periods that are different from one another as well as respective first and second azimuthal mode numbers, denoted *m*₁*, m*₂, that are different from one another. In this design, the output coupling grating may be configured to extend over an angle *ϕ* that is related to the difference between the first and second azimuthal mode numbers, denoted Δ*m* = |*m*₁ - *m*₂|, such that the product Δ*m* · *ϕ* is selected from the group: greater than or equal to 360 degrees (2*π*); greater than or equal to 180 degrees (*π*); and greater than or equal to 90 degrees (*π*/2).

In yet another specific design, the mode selecting grating and the output coupling grating are arranged on different ones of the inner and outer sidewalls of the ring waveguide.

In a still further specific design, the mode selecting grating is arranged on the inner sidewall and the outer sidewall and the output coupling grating is arranged on at least one of the inner and outer sidewalls, and wherein the mode selecting grating and the output coupling grating are arranged serially around the ring waveguide.

According to alternative embodiments, instead of realizing the output coupler with a grating, the output coupler is realized with a point scatterer, such as a notch.

There are different options for metallizing the ridge sidewalls. Depending on the embodiment, one sidewall may be metallized but not the other, both sidewalls may be metallized, or neither sidewall is metallized. The choice of sidewall metallization affects how the laser light is outcoupled and whether or not a lateral optical cavity is formed by the waveguide.

In embodiments with one-sided metallization of the ridge, the semiconductor ring laser further comprises a metal layer arranged to cover the top surface of the ridge where it forms an ohmic contact, the metal layer being further arranged to cover one and only one of the inner and outer sidewalls thereby providing a metallized sidewall and an unmetallized sidewall. A one-sided metallization avoids the metal layer forming a lateral optical cavity between the inner and outer sidewalls. With a one-sided metallization of the ridge, the ring waveguide width is advantageously selected for optimum laser output power by ensuring that the phase delay accumulated between laser light coupled out of the ring waveguide through the unmetallized sidewall indirectly via reflection from the metallized sidewall and laser light coupled out of the ring waveguide through the unmetallized sidewall directly without reflection from the metallized sidewall are in phase and hence constructively interfere with each other. This may be defined by the phase delay being approximately 2*π* · *k,* e.g., in a range selected from the group: $2 π ⋅ \left(k\pm \frac{1}{3}\right) ;$ $2 π ⋅ \left(k\pm \frac{1}{4}\right) ;$ and $2 π ⋅ \left(k\pm \frac{1}{6}\right) ,$ where k is a positive integer. This provides good laser output power by ensuring that laser light contributions coupled out directly and indirectly via said reflection constructively interfere with each other.

In implementations of one-sided metallization where the metal layer covers the inner sidewall, a layer of dielectric material may be interposed between the inner sidewall and the metal layer. In one example of one-sided metallization, the outer sidewall is covered with a layer of the dielectric material, which is in turn exposed to air, and wherein the mode selecting grating and the output coupling grating are arranged on at least the outer sidewall. In another example of one-sided metallization, the outer sidewall is covered with a layer of the dielectric material, which is in turn exposed to air, and wherein the mode selecting grating and the output coupling grating are arranged at least on the inner sidewall. In a still further example of one-sided metallization, the outer sidewall is adjacent a trench that separates the top surface of the ridge from a further radially outwardly adjacent top surface, wherein the metal layer covers the top surface of the ridge and the further radially outwardly adjacent top surface but is excluded from the trench by the dielectric material.

In embodiments with two-sided metallization of the ridge, the semiconductor ring laser further comprises a metal layer arranged to cover the top surface of the ridge where it forms an ohmic contact, the metal layer being further arranged to cover both the inner and outer sidewalls, so that the metal layer forms a lateral optical cavity between the inner and outer sidewalls, and wherein the ring waveguide has a width selected such that the phase delay accumulated by laser light scattered by the output coupler and reflected from the inner and outer sidewalls is away from resonance with a mode of the lateral optical cavity. The anti-resonant condition may be defined by the phase delay being approximately 2*π* · *k +* 1/2, e.g., in a range selected from the group: $2 π ⋅ \left(k+\frac{1}{2}\pm \frac{1}{3}\right) ;$ $2 π ⋅ \left(k+\frac{1}{2}\pm \frac{1}{4}\right) ;$ and $2 π ⋅ \left(k+\frac{1}{2}\pm \frac{1}{6}\right) ,$ where *k* is a positive integer. It can thereby be avoided that the lasing mode resonates with a mode of the lateral optical cavity.

In embodiments without metallization on either sidewall of the ridge, the semiconductor ring laser further comprises a metal layer arranged to cover the top surface of the ridge where it forms an ohmic contact but not to cover either the inner or the outer sidewall. Absent metal on either sidewall, no lateral optical cavity is formed between them. One example design that avoids metallization of the sidewalls is realized by a planarizing layer of insulating material that buries the inner and outer sidewalls while leaving exposed at least a portion of the top surface for forming the ohmic contact. The metal layer is then arranged on top of the planarizing layer radially adjacent to the top surface, thereby avoiding that the metal layer covers either the inner sidewall or the outer sidewall.

According to another aspect of the invention, there is provided a method of manufacturing a semiconductor ring laser, the method comprising:
fabricating a semiconductor heterostructure by:
   - i.: providing a substrate;
   - ii.: depositing lower semiconductor layers including at least one lower waveguiding layer;
   - iii.: depositing active region layers by alternating deposition of first and second semiconductor materials having different values of band gap energy to form a multi-quantum well structure or a superlattice; and
   - iv.: depositing upper semiconductor layers including at least one upper waveguiding layer;
performing an etch to create a ring waveguide by removing selected areas of the semiconductor heterostructure to a depth extending through the upper semiconductor layers and the active region layers to form a ridge having an inner sidewall, an outer sidewall and a top surface,
wherein the etch also creates corrugations in at least one of the inner and outer sidewalls, the corrugations creating a mode selecting grating to define a ring cavity that supports a radiative and a non-radiative mode, the non-radiative mode having lower losses than the radiative mode so that the non-radiative mode becomes the lasing mode, and
wherein the etch also creates an output coupler arranged laterally on at least one of the inner and outer sidewalls such that local to the output coupler the non-radiative mode that is the lasing mode is forced into a radiative mode, or a mixed radiative and non-radiative mode, thereby to couple laser light out of the ring waveguide through at least one of the inner and outer sidewalls.

In certain embodiments, the method may be carried out such that the etch also creates further corrugations in at least one of the inner and outer sidewalls, the further corrugations creating the output coupler as an output coupling grating. In alternative embodiments, the method may be carried out such that the etch also creates a notch in at least one of the inner and outer sidewalls, the notch creating the output coupler as a point scatterer.

The above method may include, after performing said etch, depositing a passivation layer to cover the ridge; removing an area of the passivation layer to expose at least a portion of the top surface; and depositing a metallization layer over the ridge to form an ohmic electrical contact with the top surface.

In one specific design, one or both of the inner and outer sidewalls is formed during the etch by etching a trench in the semiconductor heterostructure.

Moreover, to realize embodiments which avoid metallization of the ridge sidewalls, before depositing the metallization layer, an insulating layer may be deposited over the passivation layer to bury all but the top surface of the ridge. The metal layer subsequently deposited then spreads over at least some of the top surface of the ridge and the top of the insulating layer.

### BRIEF DESCRIPTION OF THE DRAWINGS

This invention will now be further described, by way of example only, with reference to the accompanying drawings.
Figures 1 to 3 schematically illustrate a semiconductor laser chip according to an embodiment of the invention with a ring cavity.
Figure 4 schematically illustrates in plan view a semiconductor laser chip according to an embodiment of the invention with a linear cavity.
Figure 5 is a graph showing modelling results plotting temperature, T , as a function of radial distance, r, from the center of a ring cavity for a specific example design of ring cavity.
Figure 6 is a block schematic control diagram of a control system for controlling the temperature of a semiconductor laser chip according to an embodiment of the invention.
Figure 7A is an image taken with a scanning electron microscope (SEM) of an angular portion of a semiconductor ring laser according to a first variant of a lateral grating output coupler design approach at an intermediate stage during its fabrication.
Figure 7B is an SEM image of an angular portion of a semiconductor ring laser of the first variant at a later intermediate stage of fabrication compared to Figure 7A.
Figure 8 is a schematic cross-section through a semiconductor ring laser according to the first variant.
Figure 9 is a schematic cross-section through a semiconductor ring laser according to a further variant of the lateral grating output coupler design approach.
Figure 10A is a schematic drawing showing outcoupling in lateral grating output coupler designs such as shown in Figures 8 and 9.
Figure 10B is a graph plotting emitted power, P, in arbitrary units as a function of waveguide width, w, in micrometers, µm, for lateral grating output coupler designs such as shown in Figures 8 and 9.
Figure 11 is a schematic cross-section through a semiconductor ring laser according to a still further variant of the lateral grating output coupler design approach.
Figure 12 is a schematic drawing showing an arcuate portion of a conventional semiconductor ring laser in plan view.
Figure 13 is a graph showing simulation results of cavity losses, L, of the radiative mode in units of *cm*^{*-*1} as a function of waveguide width, w, in units of *nm* for two example structures with double-sided metallization of the ring waveguide.
Figures 14A and 14B show device performance characteristics of example semiconductor ring lasers with metallization of both inner and outer sidewalls.
Figure 15 is a schematic drawing of one example of how the lateral grating can be phase shifted to form an output coupler.
Figures 16A and 16B are SEM images showing an example of positive and negative *π*/2 phase shifts which are distributed over two grating teeth.
Figures 17A and 17B show simulation results illustrating how the radiative and non-radiative modes are spatially shifted with respect to the grating teeth by a quarter of the grating period.
Figure 18A is a plan view showing the light fields for a semiconductor ring laser as illustrated in Figure 15 as calculated by a numerical simulation, and Figure 18B is an enlarged view of Figure 18A.
Figure 19A is a graph plotting threshold current density *Iₜₕ* in units of *kA*/*cm*² for example lasers manufactured at each of the three corrugation depths, these lasers being made with double-sided metallization of the ring waveguide ridge.
Figure 19B is a graph to be compared with Figure 19A plotting threshold current density *Iₜₕ* in units of *kA*/*cm*² for example lasers manufactured at each of the three corrugation depths, these lasers being made with single-sided metallization of the ring waveguide ridge.
Figures 20A to 20D are schematic plan views of example semiconductor ring lasers according to different variants of the lateral grating output coupler design approach.

### DETAILED DESCRIPTION

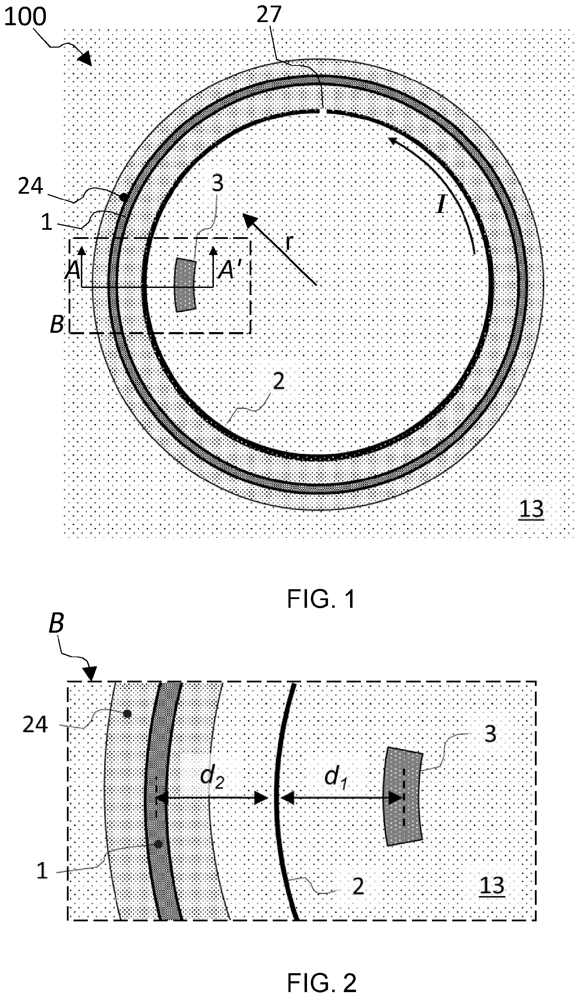

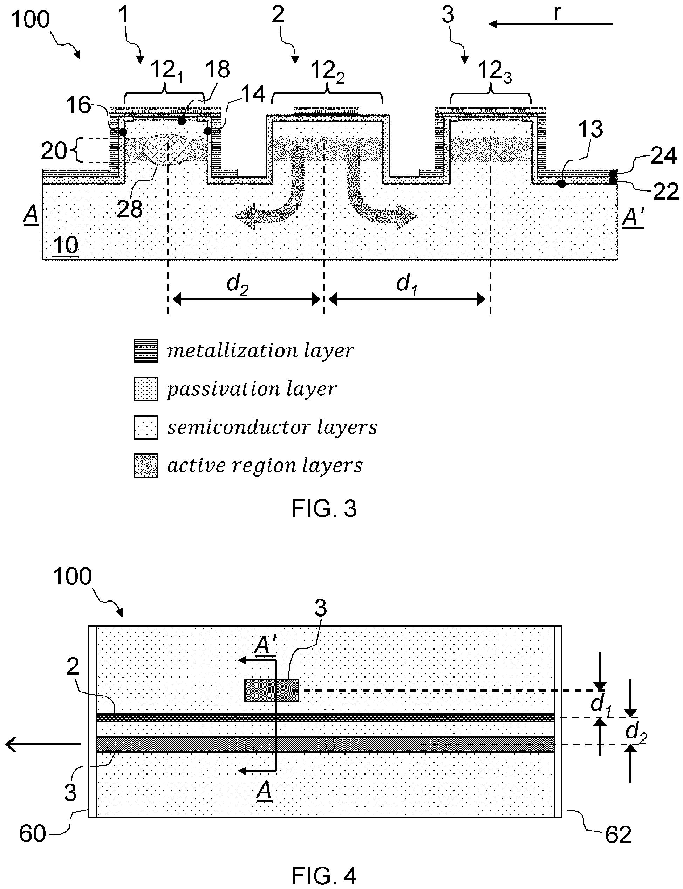

Figures 1 to 3 schematically illustrate a semiconductor laser chip 100 according to an embodiment of the invention. Figure 1 shows the semiconductor laser chip 100 in plan view. Figure 2 is also in plan view and is an enlargement of the area of box B of Figure 1. Figure 3 is a cross-section through section A-A' of Figure 1.

The semiconductor laser chip 100 comprises a semiconductor laser 1, a heater element 2 and a temperature sensor 3 in a monolithic integration. The semiconductor laser 1 is illustrated as having a ring cavity. The chip 100 has a suitable layer sequence to form the semiconductor laser 1. The same layer sequence may be shared by the heater element 2 and the temperature sensor 3. The semiconductor laser chip 100 comprises a substrate with semiconductor layers 10 epitaxially deposited thereon including active region layers 20. The epitaxial layers of the semiconductor stack are grown on a substrate by a suitable epitaxy process, such as metal-organic vapour phase epitaxy (MOVPE) or molecular beam epitaxy (MBE). The semiconductor heterostructure may be based around the GaAllnAsP or GaAllnN semiconductor materials systems, for example. The stack of semiconductor layers may be in the general form of a separate confinement heterostructure (SCH) with upper and lower cladding layers arranged above and below the active region layers in addition to cladding layers arranged above and below the active region layers. Each of these three principal monolithically integrated components, namely the semiconductor laser 1, the heater element 2 and the temperature sensor 3, is associated with a ridge 12, labelled 12₁, 12₂ and 12₃. respectively. Each ridge 12 is defined by sidewalls 14, 16, where sidewall 14 is an inner sidewall and sidewall 16 is an outer sidewall in a ring cavity design. A top surface 18 extends between the sidewalls 14, 16. The laser ridge 12₁, heater ridge 12₂ and sensor ridge 12₃ are separated by etched away portions of the stack of semiconductor layers which are etched down to a lower planar surface 13 which intersects with the bases of the sidewalls 14, 16. The loop of the heater element 2 is illustrated as having a small break 27 to split the loop and first and second electrodes (not shown) are connected either side of the break 27, via which current *I* can be caused to flow azimuthally around the loop. In other heater designs based on vertical current flow, such a break 27 is not needed.

While in this embodiment, the heater element 2 is arranged on its own ridge 12₂ this is merely an option, which is used if the heater element 2 is based on exploiting functionality provided by one or more layers of the laser layer sequence, for example to use current flow vertically across, or in a plane around, the active region layers or adjacent doped layers. On the other hand, if the heater element is of another type, such as a microheater element in the form of a metal strip deposited on the semiconductor laser chip, then the heater element 2 need not be associated with its own ridge. For example, the design of Figure 3 could be modified by etching the area that is occupied by the ridge 12₂ in Figure 3 down to the base level between the laser and sensor ridges 12₁ and 12₃, and then depositing metal for a microheater onto the surface at this base level. Various design options for the heater element 2 are described in more detail below.

In the semiconductor laser 1, the optical mode 28 is confined vertically by the cladding layers, so that it has a significant overlap with the active region layers 20 and is confined laterally by the lateral bounds of its ridge 12₁. The laser ridge 12₁ has a width, w, and a height, h, and length, *l*, along the cavity direction. In a ring cavity, the laser ridge 12₁ forms a closed loop. The laser ridge 12₁ defines a waveguide whose core intersects with the active region layers 20, the waveguide supporting an optical mode 28, in particular a cavity mode selected for lasing by the cavity design. In the illustrated design, the active region layers 20 are within the laser ridge, i.e., the laser ridge is etched down to below the active region layers 20. In other embodiments, the active region layers 20 may be below the laser ridge, i.e., the laser ridge is not etched down as far as the active region layers so that the lower planar surface 13 is above the top of the active region layers 20. A metal layer 24 forms an electrical contact with the top surface 18 of the laser ridge 12₁. Before depositing the metal layer 24, a passivation layer 22 of a dielectric material is deposited over the semiconductor surface to cover the inner and outer sidewalls 14, 16 and also adjacent areas of the planar surface 13 of the laser ridge 12₁ but leaving at least a part of the top surface 18 uncovered. A suitable material for the passivation layer 22 is Si₃N₄. Other suitable materials for the passivation layer 22 are Al₂O₃, SiO₂, and MgO. After locally etching away an area of the passivation layer 22 from the top of the laser ridge 12₁, a metal layer 24 is then deposited over the exposed top surface 18 as well as the passivation layer 22. The passivation layer 22 thus serves to electrically insulate the semiconductor stack from the metal layer 24 apart from where current injection into the semiconductor stack is needed. Since current injection into the laser structure formed in the laser ridge 12₁ is needed, an opening in the passivation layer 22 is provided at the top surface 18 of the laser ridge 12₁ as illustrated. Moreover, if the heater is based on current flow through the semiconductor material, either vertically or azimuthally through a conductive layer or layers of the semiconductor stack, then an opening in the passivation layer 22 would also be provided under the metallization of the heater, i.e., at the top surface 18 of the heater ridge 12₂. In the case of vertical current flow across the semiconductor stack, this opening would extend around the ring. In the case of azimuthal current flow around a conductive layer or layers of the semiconductor stack (e.g., as shown in Figure 1 by the small break 27), then there would be one or more pairs of local openings in the isolation layer 22 for current injection and removal. As well as serving for current injection into the top of the laser ridge 12₁, the metal layer 24 has an important role in carrying heat away from the laser during operation.

In the case of a ring cavity laser, the laser ridge 12₁ is formed in the semiconductor stack by etching a closed loop into the as *grown* semiconductor surface. The electromagnetic modes in a ring waveguide of a semiconductor ring laser are so-called whispering gallery modes (WGMs). In a ring cavity laser, output coupling needs to be integrated into material which experiences the lasing mode, such as in the ridge material for a ridge waveguide design, since there are no cavity end surfaces. One suitable method for output coupling in a ring cavity is to employ a grating output coupler. An output coupler is not shown in Figures 1 to 3 but various options for providing a suitable output coupler are discussed in detail further below. Another suitable method is to provide a coupler waveguide, which extracts light from the ring via evanescent coupling. Various known types of grating are suitable. One grating type places the grating on the laser ridge's top surface 18, as a so-called top grating [5-10]. Another grating type places the grating on one or both of the sidewalls 14, 16 of the laser ridge 12₁, as a so called lateral or side grating [10-13]. A grating may also be provided for mode selection in a DFB design of semiconductor ring laser.

Figure 4 schematically illustrates in plan view a semiconductor laser chip 100 according to an embodiment of the invention with a linear cavity. The cross-sectional structure shown in Figure 3 for a ring cavity may be the same as indicated by the section A-A' marked in Figure 4. The semiconductor laser chip 100 is cleaved and/or etched to form parallel front and back end facets 60, 62, which provide mirror surfaces of the desired reflectivity for an output coupler and rear reflector respectively at either end of the semiconductor laser 1. One or both of the end facets 60, 62 are optionally coated with layers of metal and/or dielectric material to increase or decrease their reflectivity and/or increase the damage threshold for catastrophic optical damage. The heater element 2 extends parallel to the semiconductor laser 1 separated by a distance d₂. The temperature sensor 3 is arranged on the opposite side of the heater element to the semiconductor laser, being separated by a distance d₁ from the heater element 2.

The heater element 2 in the illustrated design is accommodated on a ridge of the same height as the laser ridge 12₁, namely the heater ridge 12₂, and hence shares the layer sequence designed for the laser 1. This provides the option of basing the heating on current flow vertically or azimuthally through layers of the laser layer sequence, such as vertically across the active region layers 20 or azimuthally around a doped semiconductor layer above the active region layers 20. In the illustrated design of Figure 1, however, the heating function is activated by passing current, *I*, azimuthally around a metal heater element that is arranged on the top surface of the heater ridge 12₂ and that is provided with the above-mentioned break or split 27 for this purpose. Heat generated by the heater element 2 is conducted away through the semiconductor material, which is a relatively good thermal conductor, both in the direction of the laser 1 and the temperature sensor 3, as illustrated schematically in Figure 3 by the two thick curved arrows. It will be understood that a temperature gradient will therefore arise between the heater element 2 and each of the laser 1 and the temperature sensor 3.

The temperature sensor 3 is accommodated in the temperature sensor ridge 12₃. The temperature sensor 3 in the illustrated design shares the layer sequence designed for the laser 1. This has the advantage of re-using the laser layer sequence and thus avoiding etching and regrowth. In the sensor ridge 12₃, the active region layers 20 act as a resistive temperature sensor which measures temperature through the effect that the resistance of the active region layers of a semiconductor layer stack decreases with temperature, as described in Ristanic *et al* [4].

There are different options for forming the heater element as an integral part of the semiconductor laser chip:
1. The heater element is based on the laser layer sequence, wherein heating is provided by passing current through a part of the active region layers of the chip that is laterally offset from the waveguide and hence not functionally part of the laser. The active region layers of the semiconductor layer stack are thus repurposed for use as the heater element. To ensure the laser operation is not affected by the heater element a trench can be etched between the laser where the waveguide is formed and the heater element.
2. The heater element may be provided by passing current through a part of a doped semiconductor layer of the chip that is laterally offset from the waveguide and hence not functionally part of the laser. To ensure the laser operation is not affected by the heater element a trench can be etched between the laser where the waveguide is formed and the heater element. The doped semiconductor layer may be a layer of the semiconductor layer stack grown for the laser. Alternatively, etching and regrowth may be used to etch away certain layers of the semiconductor layer stack for the laser and then regrow one or more layers of doped semiconductor specifically for the heater element.
3. The heater element may be provided by a microheater element in the form of a metal strip, e.g., of gold, deposited on the semiconductor laser chip and extending parallel to the waveguide. The heater element described above with reference to Figures 1 to 3 is of this type. The thickness, width and length of the metal strip specify the heater resistance and thus specify the heating power as a function of applied voltage, V, noting that heating power scales according to *V*²/*R* , where R is resistance. The metal strip can be electrically separated from the semiconductor layer stack by arranging a suitable electrically insulating layer, e.g., a passivation layer or dielectric layer, on the semiconductor layer stack. The metal strip must of course also be electrically separated from the laser drive contacts.

There are different options for forming the temperature sensor as an integral part of the semiconductor laser chip:
1. A resistive temperature sensor which measures temperature through the effect that the resistance of the active region layers of a semiconductor layer stack decreases with temperature, as described in Ristanic *et al* [4]. (The temperature sensor described above with reference to Figures 1 to 3 is of this type.) The temperature sensor is separated from the heater element and/or waveguide by a trench to allow the active region layers to be repurposed for temperature sensing.
2. A pn-junction temperature sensor which measures temperature through the effect that the leakage current across a pn-junction in reverse bias increases with temperature. Etching and regrowth may be used to etch away certain layers of the semiconductor layer stack for the laser and then regrow the p-type and n-type doped semiconductor layers needed for the pn-junction temperature sensor. Alternatively, the p-type and n-type doped semiconductor layers needed for the pn-junction temperature sensor may be grown on top of a defined area of the semiconductor layer stack for the laser without etching away layers of the semiconductor layer stack for the laser. The semiconductor layers forming the pn-junction temperature sensor may be electrically isolated from the laser stack layers by a suitable insulating layer and/or by etching a trench to separate the pn-junction temperature sensor from the heater element and/or laser.
3. A resistance temperature detector (RTD) based on a thin film of metal whose resistance increases with temperature. A suitable metal is platinum. The metal is deposited on an insulating layer, e.g., a layer of dielectric material, on the top surface of the semiconductor layer stack.
4. Thermocouple: A thermocouple is a bimetallic sensor exploiting the Seebeck effect. The two metals may for example be bismuth and antimony, or nickel and chromium. The metal tracks for the thermocouple may, for example, be deposited on the passivation layer in a way that electrical separation from the laser drive current is maintained, for example at a location on the top surface of the semiconductor layer stack.

Since the role of the temperature sensor is to measure the temperature of the lasing region, i.e., the waveguide core, the temperature sensor should be arranged such that it experiences the same temperature as the waveguide core. If the temperature sensor is arranged on one side of the heater element and the waveguide core is arranged on the other side of the heater element and their lateral distances from the heater element are the same then, assuming equal temperature gradients on both sides of the heater element, the temperature sensor will experience the same temperature as the lasing region of the waveguide core. In cross-section, the heater element is thus arranged in between the waveguide and the temperature sensor. This arrangement provides a general solution that can be employed for all permutations of heater element type and temperature sensor type. A specific solution that can be employed for some particular permutations of heater element type and temperature sensor type is to locate the temperature sensor on top of the semiconductor layers forming the laser waveguide, in which case the temperature sensor and laser waveguide will both be arranged on the same side of the heater element and, moreover, at the same (or approximately the same) lateral distance from the heater element.

For a linear cavity semiconductor laser, such as one following an edge-emitter geometry, the heat dissipation laterally away from the heater element will be more or less exactly symmetric in most cases, so when the heater element is being actuated the temperature gradients either side of the heater element will be more or less exactly equal. Locating the temperature sensor and laser waveguide at the same distance either side of the heater element will thus ensure that the temperature at the laser waveguide and the temperature at the temperature sensor are the same.

On the other hand, for a ring cavity semiconductor laser, the heat dissipation laterally away from the heater element will display some amount of asymmetry, since heat dissipation radially outwards will generally be more efficient than heat dissipation radially inwards into the enclosed center portion of the ring. To take account of such asymmetric temperature gradients either side of the heater element, the temperature sensor can be arranged at a different distance away from the heater element than the waveguide to ensure that the temperature at the waveguide and the temperature at the temperature sensor are the same. For example, if the temperature sensor is arranged radially proximal to the heater element and the waveguide radially distal the heater element, then the temperature sensor can be arranged at a greater radial distance from the heater element than the waveguide. The more general expression taking account of the possibility of asymmetric temperature gradients either side of the heater element is that the arrangement should be such that the temperature difference between heater element and the temperature sensor equals the temperature difference between heater element and the laser. In practice, asymmetry of the temperature gradients either side of the heater element is likely a relatively small effect, even for ring lasers, so the two separation distances will in most designs not be hugely different, for example the ratio of the two distances is likely in the range 0.5 to 1.5, 0.8 to 1.2, or 0.9 to 1.1. Thermal modelling at the design stage is used as a design tool to ensure the two separation distances result in the same temperature being experienced by the temperature sensor as by the laser.

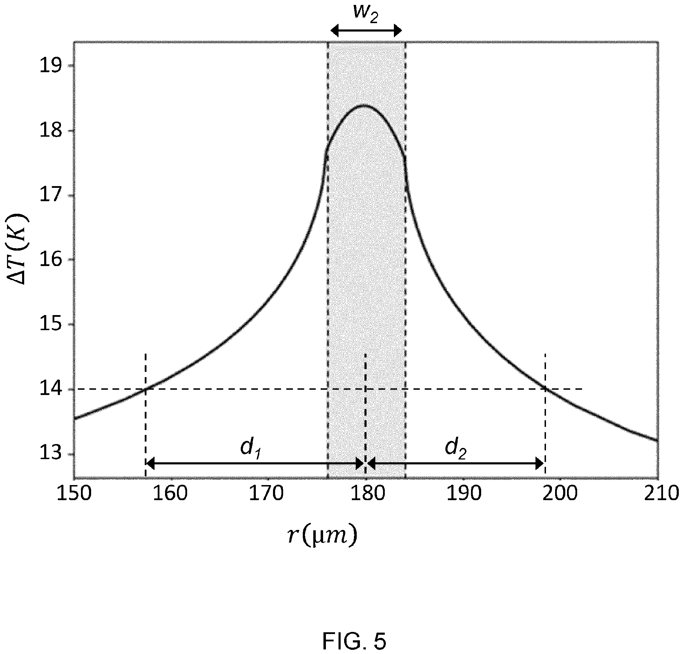

Figure 5 shows modelling results for the temperature difference, Δ*T*, which is the increase in temperature compared with when the heater element 2 is not activated, as a function of radial distance, r, from the center of a ring cavity for a specific example design of ring cavity. The temperature difference is shown in units of Kelvin. The heater element 2 is located centered at a radial distance of approximately 180 µm. The heat generating part of the heater element 2 has a width, *w*₂, which for example in the design of Figure 3 would correspond to the width of the metal strip located on the top of the heater ridge 12₂. The asymmetry of temperature gradient discussed above is visible, namely there is a slower drop off of temperature on the inside of the ring compared to the outside of the ring. This would, for example, result in specifying distances *d*₁ ≈ 22 *µm* and *d*₂ ≈ 18 *µm* in the case of alignment at *ΔT =* 14 *K* which corresponds to a ratio of approximately 1.2 or 0.8.

Generally, it will be understood that the heater element will extend over preferably the full length of the cavity to ensure the laser waveguide is heated uniformly along the whole cavity length. In the case of a DFB laser, the heater element should extend at least over the length of the DFB grating to ensure single mode selection. On the other hand, the temperature sensor can be of arbitrary size and will generally be quite small in relation to its dimension in the cavity direction, since the lateral temperature gradient will not vary along the cavity length in most usual designs owing to symmetry considerations.

For a ring cavity, the heater element can be in the form of a stripe extending at a fixed radial distance from the laser waveguide, either radially inside or radially outside the laser waveguide. Of these two options, the most efficient space usage of chip area is achieved when the heater element is arranged radially inside the laser waveguide. In this case, the heater element could also be in the form of a dot arranged radially symmetrically to fill the center portion of the area enclosed by the ring cavity. When the heater element is arranged radially inside the laser waveguide, the temperature sensor can be arranged radially inside the heater element. On the other hand, when the heater element is arranged radially outside the laser waveguide, the temperature sensor can be arranged radially outside the heater element. Alternatively, if the choice of heater element and temperature sensor permits, the temperature sensor can be arranged on top of the laser waveguide.

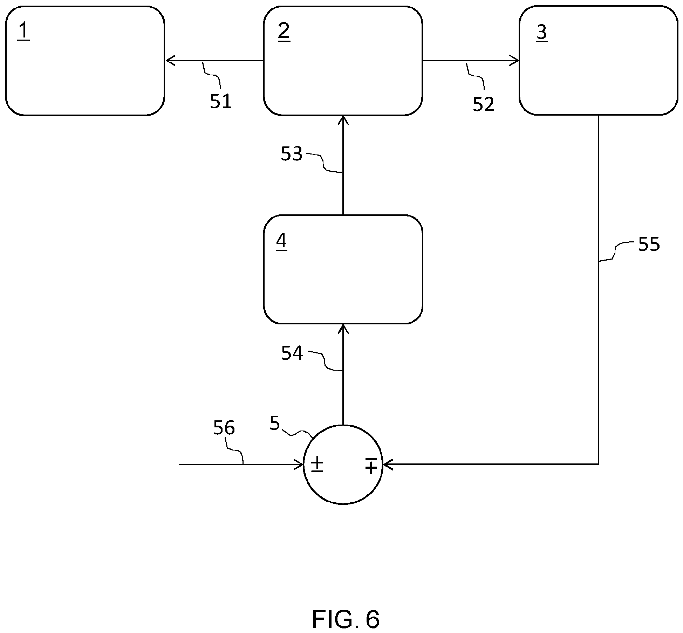

Figure 6 is a block schematic control diagram of a control system for controlling the temperature of a semiconductor laser chip 100 according to an embodiment of the invention. The temperature sensor 3 delivers a temperature signal to a controller 5 via a temperature signal line 55. The controller 5 also receives a temperature setpoint via a temperature setpoint signal line 56. The controller 5 outputs a control signal to an optional loop filter 4 via a control signal line 54. The loop filter 4 outputs a heating power signal to the heater element 2 via a heating power signal line 53. The activated heater element 2 causes a heat flux to pass to the laser 1 and to the temperature sensor 3 via respective conductive heat paths 51, 52.

To avoid dependence of the waveguide temperature and laser emission wavelength with laser operating conditions, the laser can be specified to operate under pre-defined fixed drive parameters, i.e., with a fixed injection current. Otherwise, the emission wavelength will change with changes in the injection current with which the laser is driven. This may not be an issue for designs that have a metal temperature sensor, such as an RTD or thermocouple, arranged on top of the laser ridge 12₁, since then the temperature sensor is in close proximity to the waveguide and therefore will respond to changes in the waveguide temperature. On the other hand, for designs that have a temperature sensor arranged on the opposite side of the heater element to the laser, the temperature sensor will not be sensitive to injection current dependent temperature changes of the waveguide. In such designs, it is preferable that the laser be specified to operate at a pre-defined fixed injection current, so that temperature variations of the waveguide temperature are only a function of the heater element actuation.

Design options for the output coupler in ring cavity embodiments of the invention are now discussed. One suitable type of grating output coupler places the grating on the ridge's top surface 18, as a so-called top grating. Another suitable type of grating output coupler places the grating on one or both of the sidewalls 14, 16, as a so called lateral (or side) grating.

An output coupling top grating can be fabricated adjacent the waveguide with a period matched to an integer multiple of the lasing mode period, the integer being at least two, i.e., a higher order top grating. The higher order top grating provides a scattering mechanism. The higher order top grating can be formed by etching surface corrugations into the top surface of the ring waveguide. In contrast to lateral gratings, both the symmetric and antisymmetric modes in a ring cavity with a top grating have a finite scattering loss. The top grating scatters light out of the ring cavity transverse to the plane of the ring cavity, so light is coupled out upwards through the surface of the chip and/or downwards through the substrate of the chip (which may be thinned to avoid absorption losses).

Some examples of semiconductor ring lasers with top gratings in the published literature that can be used in combination with the heater element 2 and integral temperature sensor 3 described above are:
- Hedwig Knötig et al [5]
- E. Mujagić et al [6]
- EP4329113A1 [8]
- CN105591284A [10] (FIGs. 1 to 3 thereof)

An output coupling lateral grating is fabricated on the inner and/or outer sidewall of the ring waveguide. A lateral grating is formed by etching surface corrugations of the desired period into the inner and/or outer sidewall. These sidewall surface corrugations can be formed in the same lithography step as the ring, thereby solving the alignment problem of top gratings. Moreover, the depth of the surface corrugations is in the plane of the substrate, which is orthogonal to the etch direction, so variation in etch depth does not cause variation in corrugation depth.

Some examples of semiconductor ring lasers with lateral gratings in the published literature that can be used in combination with the heater element 2 and integral temperature sensor 3 described above are:
- CN104993374A [11] (inner sidewall lateral grating)
- CN104979751A [12] (inner sidewall lateral grating)
- Amir Arbabi et al [13] (inner sidewall lateral grating)
- CN105591284A [10] (outer sidewall lateral grating in FIG. 6 thereof)

In addition, CN105591284A, and also a corresponding journal publication by the same authors:
X. Ma, Q. Chen, Q. Lu, and W. Guo, "A Novel Surface-Emitting Laser based on Microcylinder Cavity Etched with Second-Order Gratings," in Asia Communications and Photonics Conference 2016, OSA Technical Digest (online) (Optica Publishing Group, 2016), paper AF2A.66 [14]
disclose a ring laser which combines a top grating and a lateral grating. In this design, the top grating acts as the output coupler (to output vertically) and the lateral grating selects the mode which lases, where the above-mentioned condition *m*₁ = *m*₂ is satisfied by the lateral grating. This approach can also be used in combination with the heater element 2 and integral temperature sensor 3 described above

In addition to these known designs of top grating and lateral grating output coupler, a specific further form of output coupler for the ring laser 1 is now described in detail that can be used in combination with the heater element 2 and integral temperature sensor 3 described above.

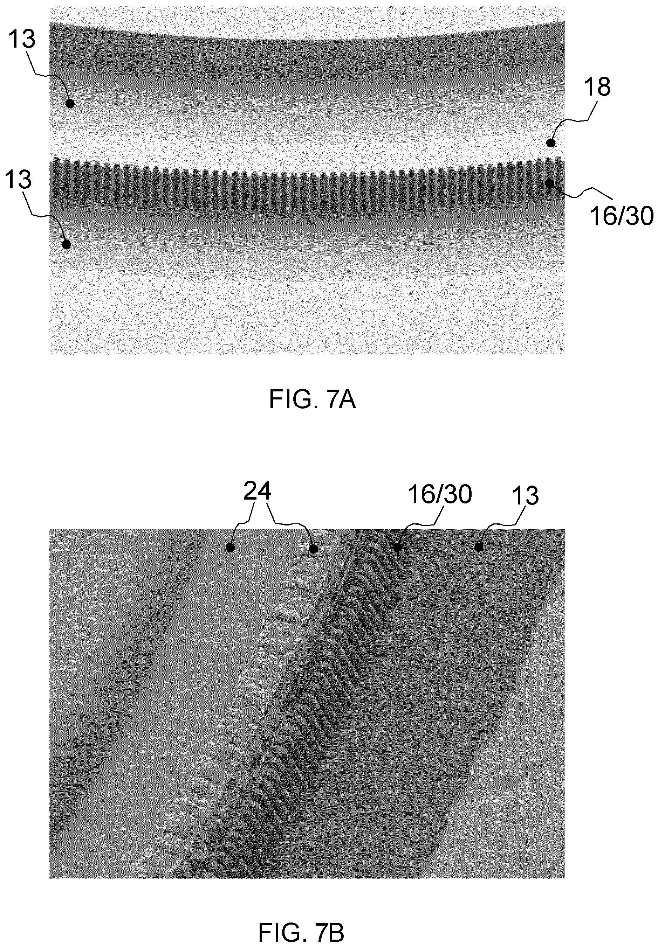

Figure 7A is an image taken with a scanning electron microscope (SEM) of an angular portion of a semiconductor ring laser with such an output coupler, showing the laser at an intermediate stage during its fabrication. At the illustrated stage in fabrication, the ring waveguide has been formed by etching and, during the same etch step, a lateral grating 30 has been formed on the outer sidewall 16.

Figure 7B is an SEM image of an angular portion of the semiconductor ring laser at a later intermediate stage of fabrication compared to Figure 7A. This is the stage after finishing the cleanroom process, i.e. before device singulation. A passivation layer (not visible) and then a metal layer 24 have been deposited onto the etched ring shown in Figure 7A leaving the grating-bearing outer sidewall 16 free of metal. The metal layer 24 covers the ridge's top surface 18, the inner sidewall 14 and an area of the planar surface 13 radially inside the ring waveguide.

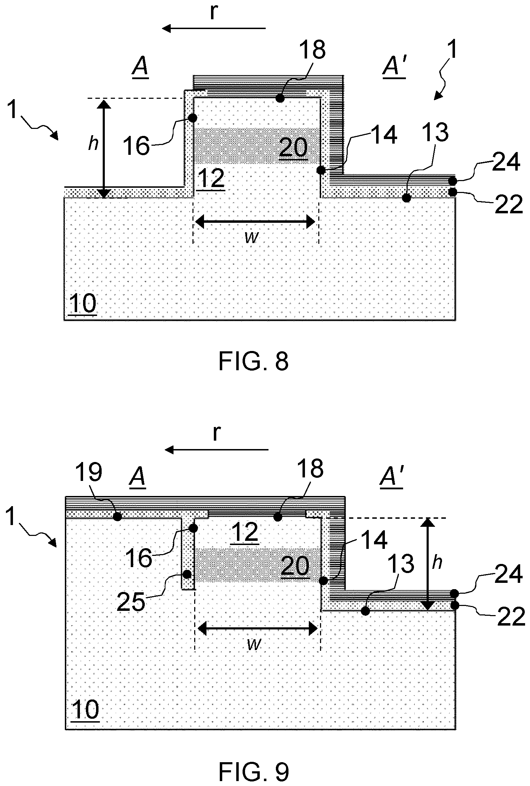

Figure 8 is a schematic diagram of a cross-section of a semiconductor ring laser 1 according to the design shown in Figures 7A and 7B. The semiconductor ring laser 1 is based on a semiconductor heterostructure comprising a substrate which has had semiconductor layers 10 epitaxially deposited thereon including active region layers 20. The stack of semiconductor layers is in the general form of a separate confinement heterostructure (SCH) as described further above. The active region for forming the ring laser can follow any known design such as by way of example an interband MQW LD, a QCL, an ICL or a quantum dot laser. For this reason, the precise layer sequence of the active region has not been described in detail. For a QCL, the most common designs are bound-to-bound, bound-to-continuum and continuum-to-continuum, any of which is suitable for use with this novel design of lateral grating output coupler. The optical mode is confined vertically by the waveguiding layers so that it has a significant overlap with the active region layers 20. A ring waveguide is formed in the semiconductor stack by etching a ring-shaped ridge 12 of width, w, and height, h, into the semiconductor surface so that the ridge 12 is elevated above an etched planar surface 13. The ring-shaped ridge 12 has an inner sidewall 14, an outer sidewall 16 and top surface 18. A metal layer 24 is needed to form an ohmic contact with the ridge's top surface 18. Before depositing the metal layer 24, a passivation layer 22 of a dielectric material is deposited over the semiconductor surface including the ridge 12. The dielectric material is then removed from an area of the ridge top surface 18 with a reactive ion etching (RIE) step. A suitable material for the passivation layer 22 is Si₃N₄. Other suitable materials for the passivation layer 22 are Al₂O₃, SiO₂, and MgO. A metal layer (or layer combination) 24 is then deposited over the exposed top surface 18 as well as the radially inner part of the passivation layer 22. In fact, the metal layer may be deposited over all areas and then removed by a lift-off process from the outer sidewall 16. The passivation layer 22 thus serves to electrically insulate the semiconductor stack from the metal layer 24 apart from at the top surface 18 where the contact for current injection is formed. The metal layer 24 provides a top electrical contact, more specifically an ohmic contact. A bottom ohmic contact (not shown) is also formed, so that the top and bottom contacts together provide for carrier injection vertically across the active region layers 20. For example, the top contact can be formed first by depositing a first metal layer (for example with Ti, Pt, Au or an alloy therebetween) on the top surface 18 of the ridge 12 and then by depositing a second metal layer (for example by electroplating with Au) on top of that with these two metallization processes collectively forming the metal layer 24. The metal layer 24 not only has the electrical function of providing the top ohmic electrical contact but also has a thermal function to provide for heat extraction of the heat generated in the ring waveguide by the lasing action. The top contact layer between the top of the semiconductor stack and the electroplated thicker metal layer is provided for good adhesion and materials' compatibility. The bottom (or base) contact (not illustrated) is formed on the bottom surface of the substrate or an exposed part of the planar surface 13 that is well away from the ridge 12 using metallization, for example with a material or material combination selected from Ge/Au/Ni/Au or an alloy therebetween.

A higher order lateral grating (not shown) is applied to the outer or inner sidewall of the annular waveguide or on both sidewalls, the grating having a period $p = k ⋅ \frac{λ}{2 ⋅ {n}_{eff}}$ with k being an integer larger than 1. The waveguide and grating can be formed in the same etching step. Alternatively, the waveguide and grating could be formed in separate etch steps. In the following, the case of the lateral grating being formed on the outer sidewall is pursued.

There are two notable design features of the ring laser of the lateral grating design according to Figure 8. First, there is the fact that the metal layer is absent from the outer sidewall as mentioned above. Second, what has not yet been mentioned, is that the lateral grating is phase shifted over a length portion of the ring to induce outcoupling laterally from the ring in that length portion. These two design features are now discussed in turn.

### Avoidance of double-sided metallization

In the lateral grating design according to Figure 8, the metal layer is absent from the outer sidewall. A more general formulation of this feature is that the metal layer is arranged so that it does not bound the waveguide on both sides.

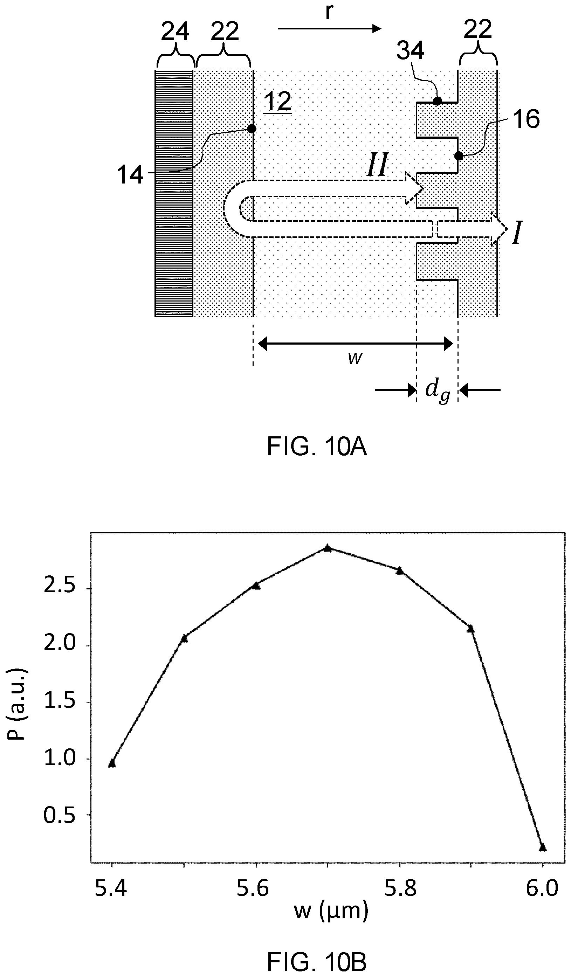

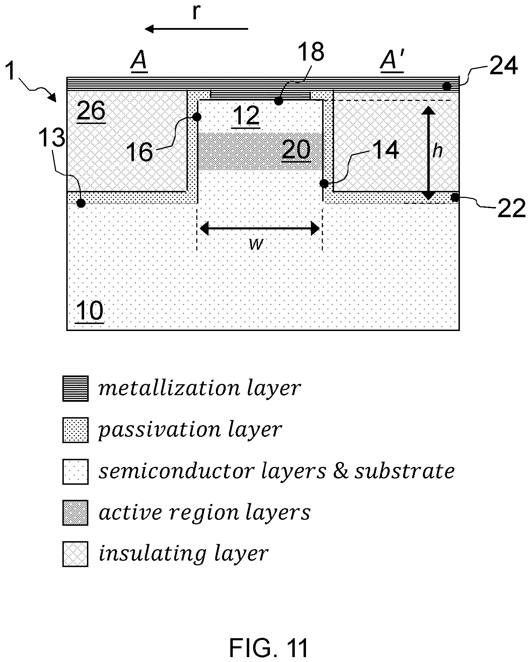

It is also noted that, while Figure 7B shows the lateral grating being free of the metal layer, in other variants of this lateral grating design approach, the lateral grating could be buried by the metal layer, for example by modifying the structure of Figure 7B to move the lateral grating to the inner sidewall 14 or by modifying the structure of Figure 7B to deposit the metal onto the outer sidewall and leave the inner sidewall free of metal. In still further variants of this lateral grating design approach, both inner and outer sidewalls could have lateral grating corrugations, and the metal layer could be deposited so as to leave one or both of the inner or outer sidewall free of metal. Some specific options for variation are now described with reference to Figures 10 and 11.

Figure 9 shows a cross-section of the ring according to another variant of this lateral grating design approach in which the metal layer 24 covers the inner sidewall 14 but not the outer sidewall 16. In this variant, before depositing the passivation layer 22, a narrow trench 25 is etched down into the semiconductor stack to form the outer sidewall 16 of the ridge 12 whereas the inner sidewall 14 is formed as in the variant of Figure 8 by a large area etch. The etch to form the trench 25 also forms the surface corrugations of the lateral grating (not shown). The top of the trench 25 is bounded on the radially inner side by the ridge top surface 18 and on the radially outer side by an elevated surface 19 that like the top surface 18 has not been etched and so is coplanar therewith. The passivation layer 22 is then deposited to cover the elevated surface 19 radially outward of the trench 25, the ridge inner sidewall 14 and the etched planar layer 13. The passivation layer material also fills the trench 25, or at least blocks the top of the trench, so that subsequent metal deposition of metal layer 24 excludes metal from entering the trench 25.

Figures 8 and 9 are examples of designs that have single-sided (or one-sided) metallization of the ridge. With one-sided metallization, there are two components of light that are coupled out from the waveguide by the output coupler.

Figure 10A is a schematic drawing of this effect which is now described by way of example in the case that the unmetallized sidewall is the radially outwardly facing sidewall 16 and also bears the lateral output coupling grating 34. There is a first component, *I*, of outcoupled laser light, arising from the output coupling grating 34 causing radially outward scattering, in which case the scattered light exits the waveguide formed by the ridge 12 and passivation layer 22 directly. There is also a second component, *II,* arising from the output coupler causing radially inward scattering, in which case the scattered light is reflected from the metallized sidewall 14 before exiting the waveguide through the unmetallized sidewall 16. Maximum outcoupling efficiency is achieved when these two components are in phase with each other, so that both components interfere constructively, i.e. accumulate a phase difference between each other of 2*π · k,* where *k* is a positive integer. The phase difference is selected by appropriate specification of the waveguide width, w, which is defined by the ridge width, the passivation layer thickness and the corrugation depth, *d_{g}* , of the lateral output coupling grating 34.

Figure 10B is a graph plotting emitted power, P, in arbitrary units as a function of waveguide width, w, in micrometers, µm, for an example design with one-sided metallization showing how output power falls off when the phase difference between the two output components increases. The in-phase condition is met at a waveguide width of 5.7 µm, where maximum output power is observed, and the output power gradually decreases as the phases of the two output components become increasingly mismatched and start to destructively interfere.

Figure 11 shows a cross-section of the ring according to a still further variant in which the metal layer 24 covers neither the inner sidewall 14 nor the outer sidewall 16. This is achieved as follows. After deposition of the passivation layer 22, the surface 13 and ridge 12 are planarized by deposition of an electrically insulating material, such as a polymer, to bury all but the top surface of the ridge. The sidewalls 14, 16 of the ridge are thus buried while leaving the ridge top surface 18 exposed on a planar top surface. Suitable polymers include benzocyclobutene (BCB), SU-8 photoresist, cyclic olefin copolymer, and polymethyl methacrylate (PMMA).

The metallization then proceeds to form the top contact, with the metal layer being kept away from the ridge sidewalls 14, 16 by the planarizing layer 26.

The reason why it is advantageous to follow the design approach of avoiding metallizing both of the sidewalls 14, 16 as exemplified by Figures 9 to 11, is now discussed.

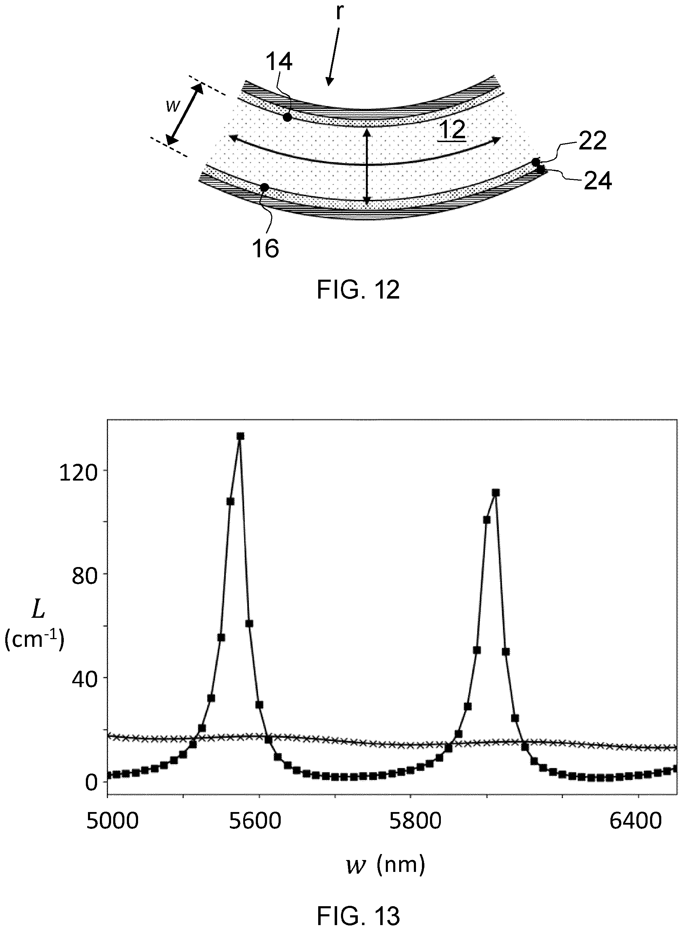

Figure 12 is a schematic drawing showing an arcuate portion of a conventional ring laser in plan view. The ridge has metallization on the inner and outer sidewalls. The metallized sidewalls are reflective to light propagating in the ring waveguide, resulting in the sidewalls forming a cavity in the radial direction of the ring, with a cavity length set by the width of the ridge and the thickness of the passivation layer. The ring waveguide will thus support unwanted radial modes in addition to the desired longitudinal modes around the ring, as indicated schematically by the radially and azimuthally extending arrowed lines.

Figure 13 is a graph showing simulation results of cavity losses, *L*, of the radiative mode in units of *cm*^{*-*1} as a function of waveguide width, w, in units of *nm* for two simulated cases. The strongly peaked curve with square points shows how varying waveguide width (e.g. by changing ridge width) affects cavity losses when both sidewalls are coated with metals. There are two pronounced peaks with losses of over 100 *cm*^{*-*1} shows the radiative mode losses when the inner and outer sidewalls are both covered with metal and hence form a lateral optical cavity that couples with light scattered from the lateral grating (Figure 1B situation). The flatter curve with the cross points is a corresponding simulation but with both sidewalls free from metals. As a result, there is no lateral cavity formed and there are no strong resonances in the radiative mode losses (Figure 11 situation). Comparing the two curves, it is evident that the lateral cavity causes large losses for light propagating in the waveguide whenever the lateral cavity resonance wavelength approximates to the lasing wavelength, since the waveguide losses are resonantly enhanced by the lateral cavity. The coupling to the lateral cavity is induced by light scattered by the grating which couples to the lateral cavity if the resonance condition is met, i.e., if the phase delay of the light from traversing the waveguide laterally once is equal to an integer multiple of 2*π*. This light is then lost by absorption of the metal on the sidewall. Resonance with the lateral cavity thus resonantly enhances the losses that arise from small process variations which lead to partial lasing in the symmetric mode. The unwanted losses caused by imperfections channeling small amounts of power into the symmetric mode are strongly influenced by many parameters. Among the most important ones are variations in any of the following: waveguide width (which scales with ridge width), grating depth (i.e., corrugation depth for a lateral grating), and thickness of the passivation layer on the sidewalls. Since the amount of power transferred to the symmetric mode depends on these uncontrolled process variations, the magnitude of these losses in any given individual device is uncontrollable, i.e., they randomly vary in magnitude from device to device. It is therefore these inherently uncontrollable losses that are being resonantly enhanced by scattering from the grating coupling to the lateral cavity. In the simulation of Figure 13, even if 5% of the cavity mode power were lasing in the radiative mode owing to process imperfections, this would result in unwanted losses of more than 5 *cm*⁻¹*.*

It can thus be understood why metallizing in such a way as to avoid forming a lateral optical cavity will suppress formation of unwanted radial modes and avoid the possibility of making a device which resonantly enhances the uncontrollable losses caused by fabrication imperfections channeling small amounts of power into the radiative mode. This is important from a yield perspective, since as mentioned above, not all the process parameters are under perfect control, so removing the possibility of such resonant enhancement of these uncontrolled losses relaxes the parameter space in which highly efficient lasers are produced and reduces the statistical spread of losses within any given manufactured batch.

**Alternative to elimination of lateral optical cavity formation:** An alternative solution for fabricating ring lasers so they are less sensitive to fabrication imperfections becomes clear once one has an appreciation of the radial mode problem. Namely, metallization of both the inner and outer sidewalls can be tolerated provided that parameters that define the lateral cavity length (principally ridge width, passivation layer thickness on the sidewalls, and lateral grating corrugation depth) are selected in combination with other relevant parameters, so that the laser operates well away from the peak losses where the lateral cavity resonates with the radiative mode at the lasing wavelength. The resonance condition to be avoided is when the phase delay accumulated at the laser wavelength when the light propagates laterally across the waveguide twice, i.e. back and forth once, is equal to $2 π ⋅ k$ where k is a positive integer. By the same token, the precisely off-resonance condition is at $2 π \left(k+\frac{1}{2}\right)$

With reference to Figure 13, it can be seen that exact compliance with the off-resonance condition is not necessary. Rather, resonance is avoided over quite a large range, as shown in the figure by the range over which the radiative mode losses of the peaked curve are lower than those of the radiative mode losses for the flatter curve. However, in practice this is a more complicated approach to realize than simply avoiding metallizing both sidewalls, since it relies on good control of the fabrication processes to avoid any of the devices being close to resonance.

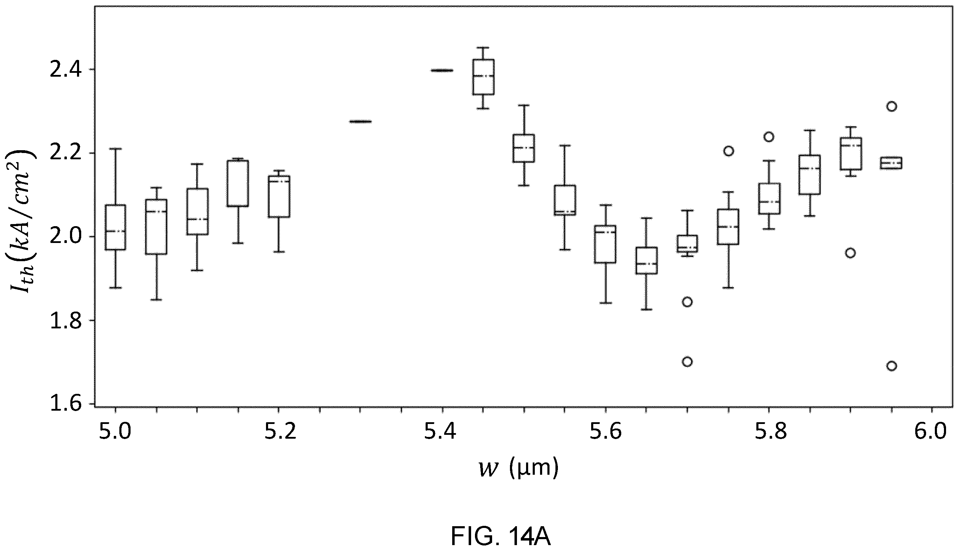

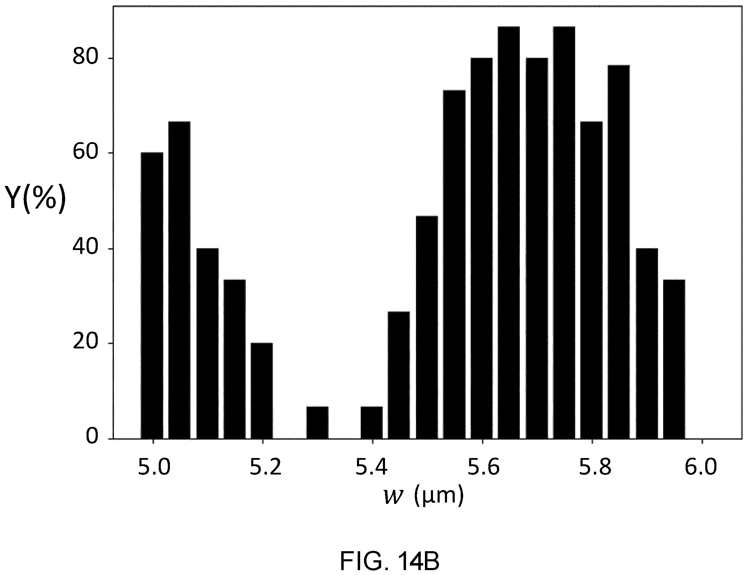

Figures 14A and 14B show device performance characteristics of a batch of example semiconductor ring laser devices fabricated with metallization of both inner and outer sidewalls. The waveguide width of this batch of example semiconductor ring laser devices was varied over more than a full period of the lateral cavity resonance.

Figure 14A is a box plot of threshold current density *Iₜₕ* in units of *kA*/*cm*² against waveguide width w in micrometers. The best performing devices, i.e., the ones with the lowest threshold current densities, are centered around waveguide widths at approximately 5.0 µm and 5.6 µm, corresponding to where the waveguide widths are farthest away from the resonance condition. On the other hand, the worst performing devices, i.e., the ones with the highest threshold current densities or the ones that did not lase at all, are centered around waveguide widths at approximately 5.3 µm, corresponding to where the waveguide widths are closest to the resonance condition.

Figure 14B is a bar chart plot of yield in percent against waveguide width w in micrometers for the same batch of devices as shown in Figure 14A. The yield is high away from the resonance condition (correlating with the low threshold current density devices of Figure 14A) whereas the yield is zero or extremely low close to the resonance condition, corresponding to no or hardly any functioning devices being fabricated when the waveguide width is poorly chosen. Yields at or above about 80% were achieved in a range of waveguide widths closest to the off-resonance condition.

### Non-radiative mode perturbation

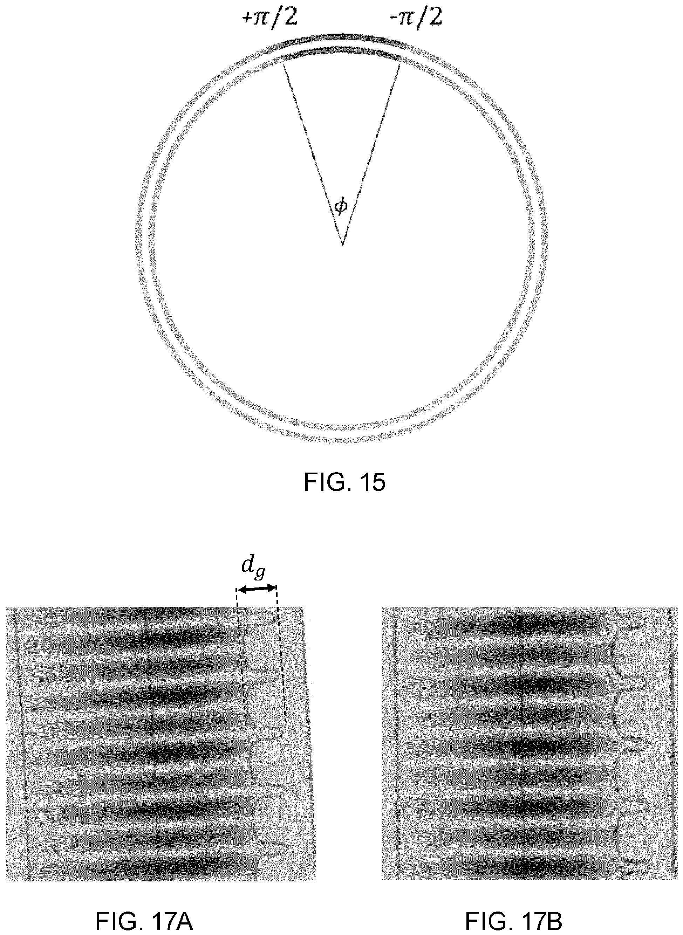

Figure 15 is a schematic drawing of one example of how the lateral grating can be phase shifted to form an output coupler for the laser. The lateral grating is provided with equal and opposite phase shifts *φ* equal to one quarter of the grating period (or *π*/2 and -*π*/2 in phase space), the locations of the two phase shifts being offset from each other around the ring by an angle *ϕ*.

Provided that the emission arc angle *ϕ* between the two phase shifts is not too large, the cavity mode will prefer to be in the non-radiative mode for the larger angular portion of the ring cavity and in the radiative mode in the smaller angular portion between the two phase shifts.

The emission arc angle *ϕ* is smaller than *π* (180°). The emission arc angle *ϕ* is preferably less than or equal to *π*/2 (90°), and still more preferably less than or equal to *π*/4 (45°), and yet still more preferably less than or equal to *π*/6 (30°).

The scattered field is shown in gray scale and can be seen to be much increased within the emission arc angle *ϕ*. The reason why the provision of equal and opposite phase shifts around a relatively small angular portion of the ring induces efficient outcoupling can be explained by the fact that the non-radiative mode and the radiative mode have different phase alignment (or symmetry) with respect to the teeth of the lateral grating. Namely, the two modes are spatially shifted with respect to the grating teeth by one quarter of the grating period (or *π*/2 in phase space).

Each phase shift may take place at a single "tooth" of the grating or can be distributed over several grating "teeth", i.e., several grating periods.

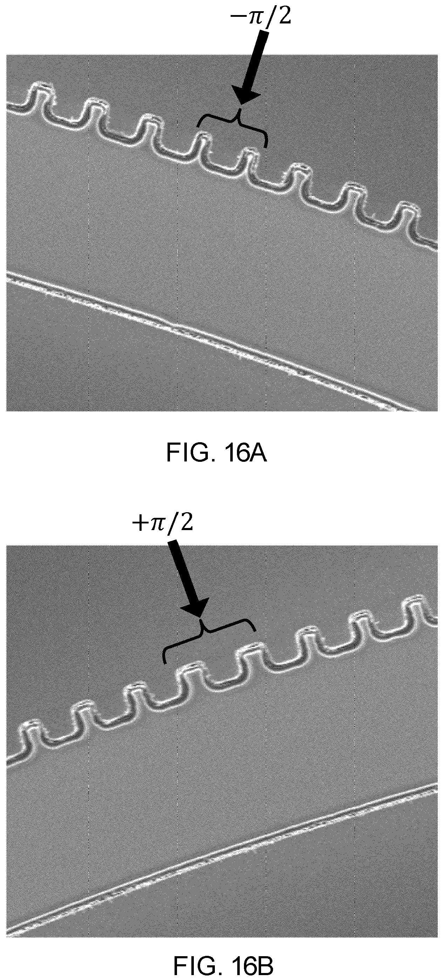

Figures 16A and 16B are SEM images showing an example of positive and negative *π*/2 phase shifts which are distributed over two grating teeth.

Figures 17A and 17B show simulation results illustrating how the radiative and non-radiative modes are spatially shifted with respect to the grating teeth by one quarter of the grating period (or *π*/2 in phase space). The shading shows electric field strength. The non-radiative mode is illustrated in Figure 17A and the radiative mode is illustrated in Figure 17B. Figure 17A also marks the corrugation depth *d_{g}* of the lateral grating which is the physical depth of the grating teeth in the radial direction as produced by the etch.

The amount of scattering loss can be tuned by increasing or decreasing the emission arc angle *ϕ* between the locations of the equal and opposite *π*/2 phase shifts around the ring, thereby tuning the proportion of laser light propagating in the ring cavity that is coupled out, analogous to tuning the reflectivity of an output coupler mirror in a classic free-space linear cavity laser.

It will be understood that the lateral grating may be formed on the inner and outer sidewalls, or on only the outer sidewall, or on only the inner sidewall.

The amount of scattering loss can also be tuned by moving the magnitude of the equal and opposite phase shifts away from *φ* = *π*/2 (90 degrees), since the scattering loss scales with the magnitude of the phase shift. Maximum scattering loss is achieved at *φ* = *π*/2 and this reduces following a sinusoidal function as one moves away from this maximum, e.g., scattering loss is reduced by half by shifting *π*/3 (60 degrees) away from the peak at *φ* = *π*/2. The magnitude of the equal and opposite phase shifts can thus be selected to be almost any desired value depending on the strength of the output coupling per unit length of the emission arc that is needed.

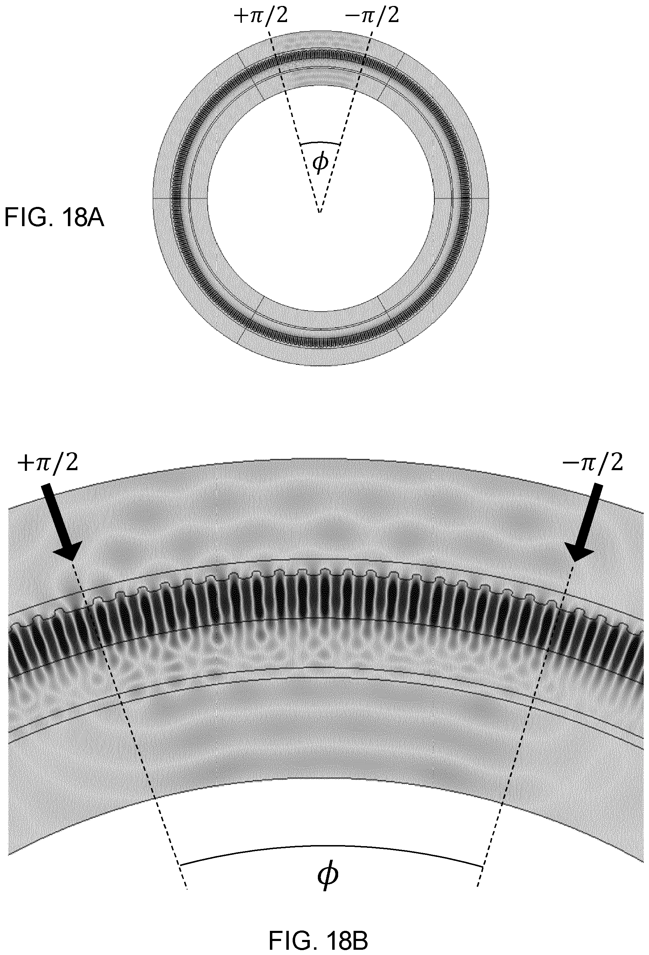

Figure 18A is a plan view showing the light fields for a semiconductor ring laser as illustrated in Figure 15 as calculated by a numerical simulation, and Figure 18B is an enlarged view of Figure 18A. The light fields show not only the modes as existing within the ring waveguide but also the light that is coupled out of the ring waveguide within the emission arc. As in Figure 15, the semiconductor ring laser has a lateral grating formed on the outer sidewall (and no lateral grating on the inner sidewall, and no top grating). Figure 18B is an enlarged view of the phase shifted arcuate portion of the ring waveguide defined by the angle *ϕ* with the positions of the +*π*/2 and the -*π*/2 phase shifts marked with the solid arrows. As can be seen by looking carefully at Figure 18B, the phase of the grating is shifted by quarter of a grating period (i.e. by *π*/2 in phase space) within the emission arc compared with outside the emission arc. Within the emission arc the nodes and antinodes of the field strength align with the grating teeth whereas outside the emission arc the nodes and antinodes of the field strength are spatially shifted by a quarter of a period. This alignment and quarter-period offset from alignment being indicative of the fact that the cavity mode within the emission arc is the symmetric (radiative) mode whereas the cavity mode outside the emission arc is the antisymmetric (non-radiative) mode. As can be seen in the enlarged view of Figure 18B, light is coupled out of the ring waveguide mostly within the emission arc. The outcoupled light is emitted predominantly in the plane of the chip surface but with some divergence in a direction perpendicular to the ring plane, not dissimilar to the characteristics of the output beam from a conventional edge-emitting laser diode.

### Example results

Three batches of QCLs were fabricated with lateral gratings according to the design of Figure 8 with half-sided metallization of the ring waveguide ridge, as well as three corresponding batches according to a prior art design approach with double-sided metallization of the ring waveguide ridge. The three batches of inventive examples and comparative examples all have in common that they have a lateral grating formed on the outer sidewall (and no lateral grating on the inner sidewall, and no top grating). It is noted however that the inventive examples and also the comparative examples did not incorporate a phase shift in the lateral grating. This was so that the threshold current density, absent additional losses intentionally introduced by the grating coupling to the lateral cavity, should be equal to a ring cavity without a grating which essentially supports only the non-radiative mode with no outcoupling of laser light. In other words, none of these example lasers have an output coupler feature. The three batches of inventive examples and comparative examples differ in the corrugation depth of the lateral grating. The inventive and comparative first batches have a corrugation depth *d_{g}* of 0.6 µm. The inventive and comparative second batches have a corrugation depth *d_{g}* of 0.9 µm. The inventive and comparative third batches have a corrugation depth *d_{g}* of 1.2 µm. Grating strength increases with increasing corrugation depth, so deeper corrugations are expected to cause stronger coupling to lateral cavity modes.

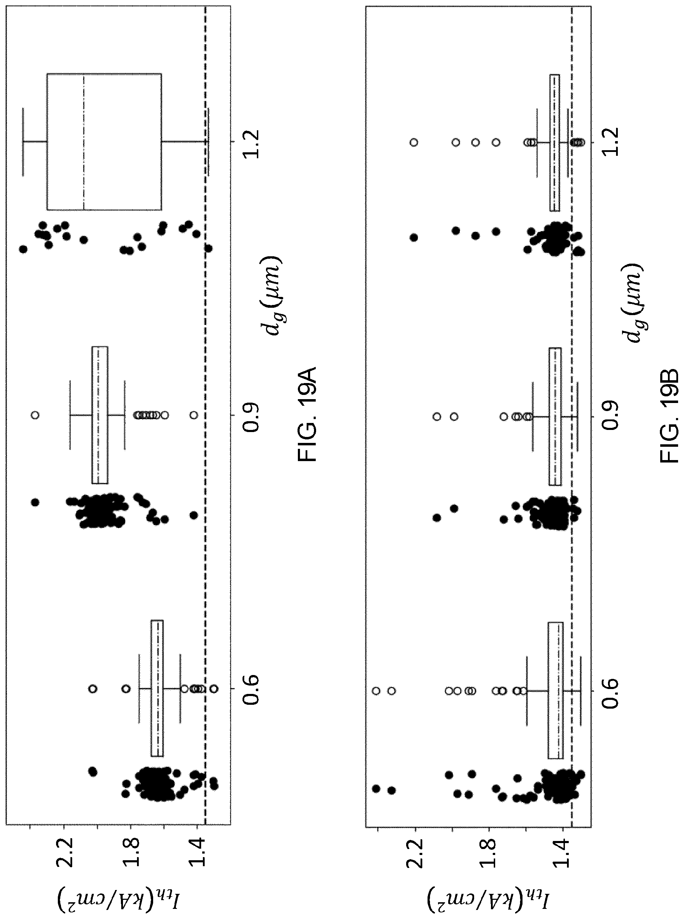

Figures 19A and 19B are box plots indicating the relative performance of the different lasers in plots of lasing threshold current density *Iₜₕ* in units of *kA*/*cm*² for each of the three corrugation depths. The box plots show the median with the dot-dashed line. The box is delimited by first and third quartile (Q1 and Q3) and the whiskers extend to Q1-1.5*IQR and Q3+1.5*IQR, where IQR=Q3-Q1. Outliers are anything beyond Q1-1.5*IQR or Q3+1.5*IQR. The outliers are marked with the empty circles. The solid circles to the left side of each boxplot have been distributed over a finite distribution on the x axis in order that their distribution can be visually appreciated, even though all the solid circles in each group have the same value of corrugation depth (*d_{g}* = 0.6, 0.9 or 1.2 µm). Figure 19A shows the three batches of comparative examples. Figure 19B shows the three batches of inventive examples. Each dot represents an individual laser device. Any non-functioning device, i.e., any device that did not lase at all, is absent from the plot, since it was not able to attain threshold. The flat dashed line in each plot indicates the threshold current density of a batch of ring laser devices fabricated with no grating, representing ideal ring cavities, the values being approximately 1.35 *kA*/*cm*²*.*

Threshold current density was chosen as the parameter to plot, since it is a good overall indicator of device quality of a laser. Absent intentional scattering losses for outcoupling, threshold current density should be low, since this indicates low losses, such as low internal losses and low cavity losses. Moreover, for a given batch of lasers that are manufactured, e.g., from the same wafer, uniformity of performance of the individual lasers, such as a narrow spread of threshold current densities, is also an indicator of quality, since that will indicate the fabrication processes are consistent and will also correlate with yield, since a wider statistical spread of performance will usually be associated with a lower yield, since more of the devices will not meet specification and will need to be discarded.

Referring to the results for the comparative examples in Figure 19A, it can be seen that the 0.6 µm comparative batch has threshold current densities closely clustered around *1.6 kA*/*cm*², which compares with the value of 1.35 *kA*/*cm*² for the ideal ring cavity (dashed line). The 0.9 µm comparative batch has significantly higher threshold current densities around approximately 2.0 *kA*/*cm*² indicating a reduction in efficiency as well as a somewhat increased spread in performance. The 1.2 µm comparative batch is a generally poor batch in that the threshold current densities are scattered over a large range and also a significant number of the devices did not lase at all. The threshold current of the three comparative batches therefore increases with increasing corrugation depth, which is an indicator of the presence of unwanted losses caused by the metal layer.

Referring to the results for the inventive examples in Figure 19B, it can be seen that all three batches have very similar characteristics in terms of threshold current density. All three inventive batches have threshold current densities closely clustered around approximately *1.4 kA*/*cm*² , very close to the value of 1.35 *kA*/*cm*² for the ideal ring cavity (dashed line), and all three batches show a narrow spread in threshold current density.

It is therefore concluded that the increase in threshold current density with corrugation depth in the comparative example devices is caused by fabrication imperfections that lead to significant coupling to the radiative mode, whose losses are enhanced by the lateral optical cavity formed between the metal layers on the inner and outer sidewalls. By comparison, the inventive example devices are much more resilient to fabrication imperfections and have threshold current densities close to the ideal value for all three corrugation depths.

### Ways to achieve perturbation of the non-radiative mode

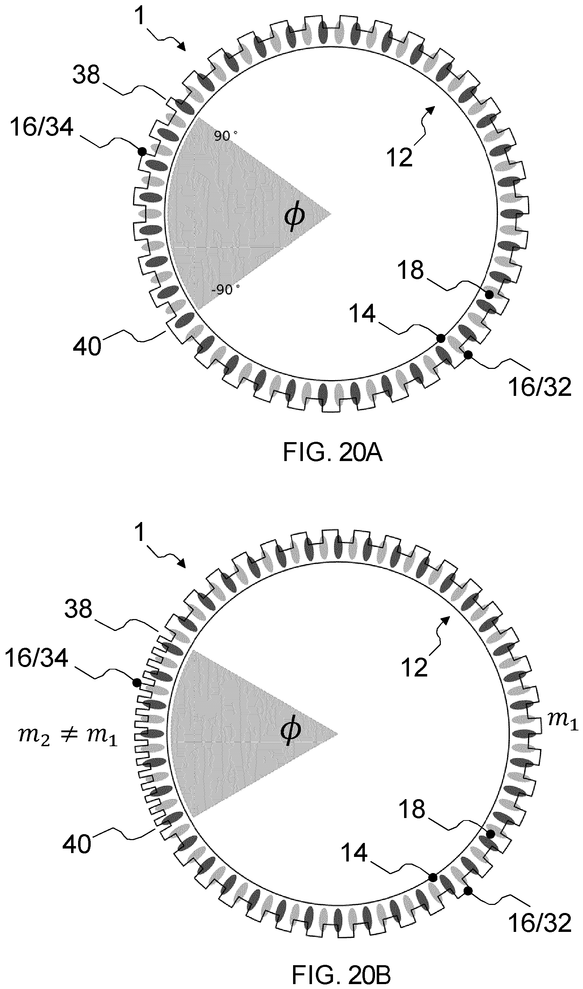

Figures 20A to 20D are schematic plan views of example semiconductor ring lasers according to different variants of this lateral grating design approach with different designs for the output coupling.

Figure 20A is a semiconductor ring laser 1 according to a lateral grating design as described above. A ridge 12 extends in a closed loop, illustrated as circular. The ridge 12 is defined by an inner sidewall 14, an outer sidewall 16 and a top surface 18. A lateral grating is integrated with the outer sidewall 16 and has a single period around the loop. The lateral grating is subdivided into major and minor arcuate sections, functioning as a mode selecting grating 32 and an output coupling grating 34 respectively, whose azimuthal mode numbers are the same, i.e., *m*₁ = *m*₂*.* The major and minor arcuate sections are separated by first and second grating transitions 38, 40 that provide equal and opposite phase shifts (offsets). As discussed above, maximum scattering loss is induced when the phase shifts have a magnitude of a quarter of the grating period (i.e., ±90°). The magnitude of the phase shift can however be set at a value away from this maximum, for example if a lower amount of scattering is desired. The minor arcuate section that accommodates the output coupling grating 34 forms an emission arc extending over an angle *ϕ*. Alternatively, the mode selecting grating 32 and the output coupling grating 34 could be formed on the inner sidewall 14, or on both the inner and outer sidewalls 14, 16.

Figure 20B is a semiconductor ring laser 1 according to another variant with a different design of the lateral grating output coupler. A ridge 12 extends in a closed loop, illustrated as circular. The ridge 12 is defined by an inner sidewall 14, an outer sidewall 16 and a top surface 18. A lateral grating is integrated with the outer sidewall 16. The lateral grating is subdivided into major and minor arcuate sections, functioning as a mode selecting grating 32 and an output coupling grating 34 respectively, whose periods are different and whose azimuthal mode numbers are also different, i.e., *m*₁ *= m*₂*..* The major and minor arcuate sections are separated by first and second grating transitions 38, 40. The change in period and azimuthal mode number promotes the lateral output coupling within the emission arc of angle *ϕ*.

Figure 20B is an example design showing how the output coupler may be formed by providing a different grating pitch within the emission arc. The grating period is changed within the emission arc to one associated with a different azimuthal mode number. The change of the azimuthal mode number between the emission arc and the remainder of the ring causes the laser to operate in a superposition of the non-radiative and radiative modes within the emission arc of angle *ϕ*. In more detail, the standing wave pattern of the electric field in the ring cavity will be dominated by the non-radiative mode of the mode selecting grating outside the emission arc, whereas, within the emission arc, the modified period of the output coupling grating will cause a periodic beating to take place between the radiative and non-radiative mode. To cover a full beating period, the angle of the emission arc *ϕ* needs to be 2*π*/Δ*m*, where Δ*m* = |*m*₁ - *m*₂|, i.e., the difference in azimuthal mode number between the mode selecting grating and the output coupling grating. However, it is not necessary to cover a full beating period. It may be enough to cover half a period *ϕ* = *π*/Δ*m* or a quarter of a period *ϕ* = *π*/2Δ*m*, for example. This may be the case if a weaker output coupling effect is preferred. Compared to variants that use equal and opposite phase shifts of *π*/2 to promote output coupling, changing the grating period only produces approximately half the losses (and hence outcoupling efficiency) per unit angle. The above comments on the preferred values of emission arc angle *ϕ* also apply to this design option. Alternatively, the lateral grating could be formed on the inner sidewall 14, or on both the inner and outer sidewalls 14, 16.

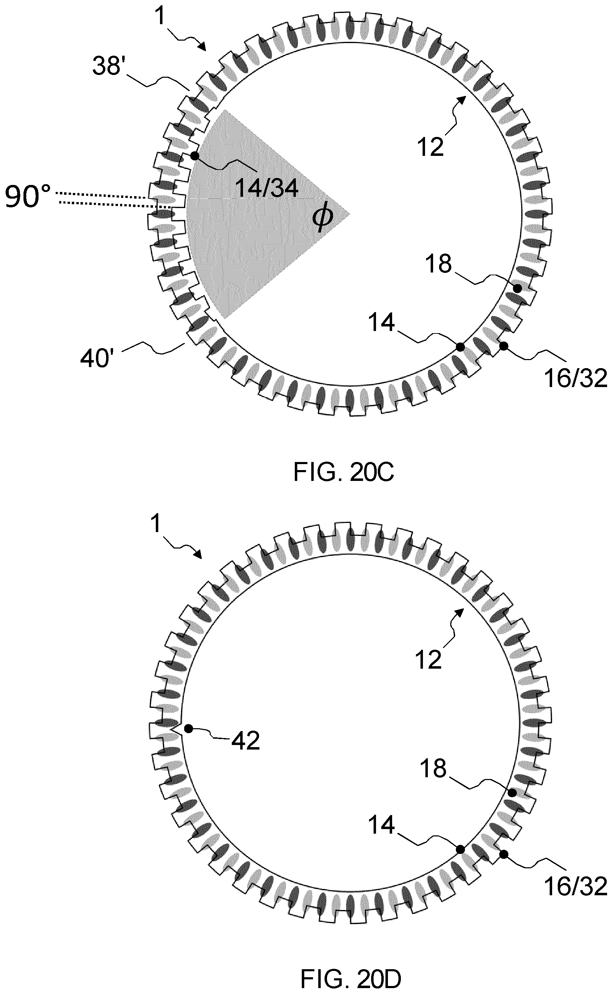

Figure 20C is a semiconductor ring laser 1 according to another variant with a different design of the lateral grating output coupler. A ridge 12 extends in a closed loop, illustrated as circular. The ridge 12 is defined by an inner sidewall 14, an outer sidewall 16 and a top surface 18. A first lateral grating is integrated with the outer sidewall 16 to function as a mode selecting grating 32 and extends around the whole loop. A second lateral grating is integrated with the inner sidewall 14 to function as an output coupling grating 34 and extends around a minor arcuate section of the loop to form an emission arc of angle *ϕ*. The mode selecting grating 32 is thus formed on the outer sidewall 16 and extends around the full loop, and the output coupling grating 34 is formed on the inner sidewall 14 and extends over a minor arcuate section of the loop bounded by first and second ends 38', 40'. Similar to the design of Figure 20A, the output coupling is induced by a quarter period phase offset between the mode selecting grating 32 and the output coupling grating 34, and, also similar to the design of Figure 20A, the mode selecting grating 32 and the output coupling grating 34 have the same period and support the same azimuthal mode numbers, i.e., *m*₁ = *m*₂*.* Figure 20C is an example design showing how the output coupler may be formed by combining a uniform pitch lateral grating around the whole ring on one sidewall and a phase shifted lateral grating limited to an emission arc of angle *ϕ* on the other sidewall. Alternatively, the inner and outer sidewalls can be switched. The above comments on the preferred values of emission arc angle *ϕ* also apply to this design option.

Figure 20D is a semiconductor ring laser 1 according to another variant with a different design of the lateral grating output coupler. A ridge 12 extends in a closed loop, illustrated as circular. The ridge 12 is defined by an inner sidewall 14, an outer sidewall 16 and a top surface 18. A lateral grating is integrated with the outer sidewall 16 and has a single period around the loop to form a mode selecting grating 32. The lateral grating 30 is continuous around the loop without any transitions in phase or period. Output coupling is instead provided by a point scatterer in the form of a notch 42 etched laterally into the inner sidewall. A lateral emission of laser light localized around the notch 42 then arises. Figure 20D is an example design showing how the output coupler may be formed by a point scattering feature arranged on a sidewall of the ridge. Alternatively, the lateral grating could be formed on the inner sidewall, or the inner and outer sidewalls, and the point scattering feature could be formed on either sidewall.

While the examples of Figures 20A to 20D have in common that there is only one output coupler, it would be possible to provide more than one output coupler, for example two output couplers, arranged at different angular positions in the ring, for example on opposite sides of the ring. In the case of an output coupling grating, the grating would then have multiple non-contiguous grating sections. In the case of an output coupler point scatterer, there would then be multiple point scatterers, for example multiple notches. The mode-selecting grating may then be split into two or more separate sections by the presence of a plurality of output couplers. Moreover, even in examples with only one output coupler, the mode-selecting grating may be split into two or more separate sections. In these examples with multiple output coupling gratings and/or a multi-section mode selecting grating, the azimuthal angles as discussed elsewhere in this document can be understood as aggregate angles made up of the sum of the contributions from the different sections of mode-selecting grating and/or output coupling grating.

In summary, the above-described examples of Figures 20A to 20D explain how there are several options for perturbing the non-radiative mode over a limited length portion of the ring and thereby induce the cavity mode to change in that limited angular range from the non-radiative mode into a mode which is either essentially entirely the radiative mode or a mode that is mixed between non-radiative and radiative components with a sizeable radiative component.

It will be clear to one skilled in the art that many improvements and modifications can be made to the foregoing exemplary embodiment without departing from the scope of the present disclosure.

### REFERENCES

[1] US2016094013A1 Applied Optoelectronics, Inc.
[2] US2015078411A1 Alpes Lasers SA
[3] WO2015081220A1 Thorlabs Quantum Electronics, Inc.
[4] Daniela Ristanic, Benedikt Schwarz, Peter Reininger, Hermann Detz, Tobias Zederbauer, Aaron Maxwell Andrews, Werner Schrenk, Gottfried Strasser; Monolithically integrated mid-infrared sensor using narrow mode operation and temperature feedback. Appl. Phys. Lett. 26 January 2015; 106 (4): 041101. https://doi.org/10.1063/1.4906802
[5] Hedwig Knötig, Borislav Hinkov, Robert Weih, Sven Höfling, Johannes Koeth, Gottfried Strasser; Continuous-wave operation of vertically emitting ring interband cascade lasers at room temperature. Appl. Phys. Lett. 30 March 2020; 116 (13): 131101. https://doi.org/10.1063/1.5139649
[6] E. Mujagić, S. Schartner, L. K. Hoffmann, W. Schrenk, M. P. Semtsiv, M. Wienold, W. T. Masselink, G. Strasser; Grating-coupled surface emitting quantum cascade ring lasers. *Appl. Phys. Lett.* 7 July 2008; 93 (1): 011108. https://doi.org/10.1063/1.2958910
[7] EP4254690A1 ETH Zürich
[8] EP4329113A1 ETH Zürich
[9] US2005238079A1 Wisconsin Alumni Research Foundation
[10] CN105591284A Huazhong University of Science and Technology
[11] CN104993374A Institute Of Semiconductors, Chinese Academy of Sciences
[12] CN104979751A Institute Of Semiconductors, Chinese Academy of Sciences
[13] Amir Arbabi, Seyedeh Mahsa Kamali, Ehsan Arbabi, Benjamin G. Griffin, and Lynford L. Goddard, "Grating integrated single mode microring laser," Opt. Express 23, 5335-5347 (2015) https://doi.org/10.1364/OE.23.005335
[14] X. Ma, Q. Chen, Q. Lu, and W. Guo, "A Novel Surface-Emitting Laser based on Microcylinder Cavity Etched with Second-Order Gratings," in Asia Communications and Photonics Conference 2016, OSA Technical Digest (online) (Optica Publishing Group, 2016), paper AF2A.66.

### REFERENCE NUMERALS

- 1: ring laser
- 2: heater element
- 3: temperature sensor
- 4: loop filter
- 5: controller
- 10: epitaxial layers
- 12: ridge
- 13: etched planar surface
- 14: inner sidewall
- 16: outer sidewall
- 18: top surface
- 19: elevated planar surface
- 20: active region layers
- 22: passivation layer of dielectric material
- 24: metal layer
- 25: trench
- 26: planarizing layer of polymer
- 27: heater break or split
- 28: optical mode
- 30': further lateral grating
- 32: mode selecting grating
- 34: output coupling grating
- 36: phase shifted angular portion
- 38: first grating transition
- 38': first grating end
- 40: second grating transition
- 40': second grating end
- 42: output coupling notch
- 51: conductive heat path from heater element to laser
- 52: conductive heat path from heater element to temperature sensor
- 53: heating power signal line
- 54: control signal line
- 55: temperature signal line
- 56: temperature setpoint signal line
- 60: front end facet, output coupler mirror
- 62: rear end facet, rear reflector mirror

## Claims

1. A semiconductor laser chip (100) comprising:
a semiconductor laser (1) formed from a stack of semiconductor layers including active region layers (20) and upper and lower cladding layers arranged above and below the active region layers, the semiconductor layer stack being structured laterally to define a waveguide having an optical mode (28) that samples the active region layers (20);
a heater element (2) formed integrally with the semiconductor laser stack and extending alongside the waveguide, the heater element being electrically actuatable to provide a heat source; and
a temperature sensor (3) formed integrally with the semiconductor layer stack.

2. The semiconductor laser chip according to claim 1, wherein the heater element (2) and the temperature sensor (3) are separated by a first distance (d₁), wherein the heater element (2) and the semiconductor laser (1) are separated by a second distance (d₂), and wherein the first and second distances are selected such that during actuation of the heater element (2) the ratio of the temperature increase experienced by the temperature sensor (3) to the temperature increase experienced by the semiconductor laser (1) in both cases compared to the temperature pertaining when the heater element (2) is not actuated is within the range 0.5 to 1.5, more preferably 0.7 to 1.3, still more preferably 0.8 to 1.2, yet more preferably 0.9 to 1.1.

3. The semiconductor laser chip according to claim 1, wherein the ratio of the first distance to the second distance is within the range 0.5 to 1.5, more preferably 0.7 to 1.3, still more preferably 0.8 to 1.2, yet more preferably 0.9 to 1.1.

4. The semiconductor laser chip according to claim 1, 2 or 3, wherein the semiconductor laser (1) and the temperature sensor (3) are arranged on opposite sides of the heater element (2).

5. The semiconductor laser chip according to claim 1, 2 or 3, wherein the semiconductor laser (1) and the temperature sensor (3) are arranged on the same side of the heater element (2).

6. The semiconductor laser chip according to any one of the preceding claims, wherein the heater element (2) is selected from the group:
a heater element formed integrally with the semiconductor layer stack that is operable to generate heat by passing electrical current through the active region layers, the heater element being electrically actuatable independent of the semiconductor laser;
a heater element formed integrally with the semiconductor layer stack that is operable to generate heat by passing electrical current through a doped semiconductor layer of the semiconductor layer stack, the heater element being electrically actuatable independent of the semiconductor laser; and
a microheater element in the form of a metal strip arranged on the top surface of the semiconductor layer stack that is operable to generate heat by application of an electrical voltage to cause resistive heating.

7. The semiconductor laser chip according to any one of the preceding claims, wherein the temperature sensor (3) is selected from the group:
a resistive temperature sensor formed within the semiconductor layer stack;
a pn-junction temperature sensor formed integrally with the semiconductor layer stack;
a resistance temperature detector comprising a metal film arranged on the top surface of the semiconductor layer stack; and
a thermocouple comprising an electrically conductive path formed by first and second serially connected metal films of different metals arranged on the top surface of the semiconductor layer stack.

8. The semiconductor laser chip according to any one of the preceding claims, wherein the semiconductor laser (1) is selected from the group:
a quantum cascade laser whose lasing action is based on cascading intraband transitions between subbands of quantum wells in a Type I superlattice structure;
an interband cascade laser whose lasing action is based on cascading interband transitions between subbands of quantum wells in a Type II or Type I superlattice structure;
a semiconductor laser whose lasing action is based on an interband transition in a Type I multi-quantum well heterostructure; and
a semiconductor laser whose lasing action is based on an interband transition of quantum dots.

9. The semiconductor laser chip according to any one of claims 1 to 8, wherein the semiconductor laser chip (100) is terminated on two sides by front and rear end facets, and wherein the waveguide extends between the front and rear end facets, so that the semiconductor laser (1) has a linear cavity bounded by the front and rear end facets.

10. The semiconductor laser chip according to any one of claims 1 to 8, wherein the waveguide of the semiconductor laser (1) extends in a closed loop thereby to form a ring cavity.

11. The semiconductor laser chip according to claim 10, wherein the waveguide of the semiconductor laser (1) is formed of a ridge (12) of semiconductor material having an inner sidewall (14) and an outer sidewall (16), and the semiconductor laser (1) further comprises:
a mode selecting grating (32) arranged on at least one of the inner and outer sidewalls (14, 16) to define the ring cavity, the ring cavity being configured to support a radiative and a non-radiative mode, the non-radiative mode having lower losses than the radiative mode so that the non-radiative mode becomes the lasing mode; and
an output coupler (34; 42) arranged on at least one of the inner and outer sidewalls (14, 16) and configured such that local to the output coupler (34; 42) the non-radiative mode that is the lasing mode is forced into a radiative mode, or a mixed radiative and non-radiative mode, thereby to couple laser light out of the ring waveguide through at least one of the inner and outer sidewalls (14, 16).

12. A laser according to claim 11, wherein the output coupler comprises an output coupling grating (34).

13. A laser according to claim 11, wherein the output coupler comprises a point scatterer (42).

14. A laser according to any one of claims 11 to 13, wherein the ridge (12) further comprises a top surface (18), and wherein the semiconductor laser (1) further comprises a metal layer (24) arranged to cover the top surface (18) where it forms an ohmic contact, the metal layer (24) being further arranged to cover one and only one of the inner and outer sidewalls (14, 16) thereby providing a metallized sidewall and an unmetallized sidewall.

15. A laser according to claim 14, wherein the waveguide has a width selected such that the phase delay accumulated between laser light coupled out of the waveguide through the unmetallized sidewall (14, 16) indirectly via reflection from the metallized sidewall (16, 14) and laser light coupled out of the ring waveguide through the unmetallized sidewall directly without reflection from the metallized sidewall is in a range selected from the group: $2 π ⋅ \left(k\pm \frac{1}{3}\right) ;$ $2 π ⋅ \left(k\pm \frac{1}{4}\right) ;$ and $2 π ⋅ \left(k\pm \frac{1}{6}\right) ;$ where k is a positive integer, thereby ensuring that laser light coupled out directly and indirectly via said reflection constructively interfere with each other.
